(19) Europäisches Patentamt
European Patent Office
Office européen des brevets

(11) **EP 4 765 699 A1**

(12) **EUROPEAN PATENT APPLICATION**

(43) Date of publication:
**24.06.2026 Bulletin 2026/26**

(21) Application number: **25221603.1**

(22) Date of filing: **08.12.2025**

(51) International Patent Classification (IPC):
**H04L 1/00** (2006.01)　　**H03M 13/11** (2006.01)

(52) Cooperative Patent Classification (CPC):
**H04L 1/005; H03M 13/1105; H03M 13/3715;
H04L 1/0051;** H03M 13/3738; H03M 13/6306

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**GE KH LA MA MD TN**

(30) Priority: **20.12.2024 KR 20240192964**

(71) Applicant: **Samsung Electronics Co., Ltd.**
**Suwon-si, Gyeonggi-do 16677 (KR)**

(72) Inventors:
• **BAE, Jimin**
**16677 Suwon-si (KR)**
• **KIM, Jinho**
**16677 Suwon-si (KR)**

(74) Representative: **Marks & Clerk LLP**
**15 Fetter Lane**
**London EC4A 1BW (GB)**

(54) **MODEM CHIP ALLOCATING MAXIMUM NUMBER OF DECODING ITERATIONS PER CODE BLOCK AND ELECTRONIC DEVICE INCLUDING THE SAME**

(57) A method of operating a modem chip may include measuring quality of a plurality of resource elements allocated to receive a codeword, allocating a maximum number of decoding iterations per code block based on a measurement result of the quality and a resource element-to-code block (RE-CB) mapping pattern corresponding to a target slot, and decoding a plurality of first code blocks of the target slot based on the allocated maximum number of decoding iterations per code block.

FIG. 5

START

MEASURE QUALITY PER RESOURCE
ELEMENT BASED ON RESULT OF DECODING
CODE BLOCKS IN MONITORING SECTION — S100

ALLOCATE MAXIMUM NUMBER OF
DECODING ITERATIONS PER CODE BLOCK
BASED ON MEASUREMENT RESULT — S110

PERFORM DECODING ON CODEWORD
BASED ON RESULT OF ALLOCATION — S120

END

**Description**

BACKGROUND

One or more embodiments of the present disclosure relate to a modem chip for processing a codeword containing a plurality of code blocks and an electronic device including the modem chip.

In communication systems, transmission devices may transmit codewords containing code blocks to receiving devices.

Such a receiving device may decode code blocks in units of code blocks for error correction. For example, the receiving device may perform low density parity check (LDPC)-based decoding on code blocks to detect and correct errors in the code blocks.

The receiving device may decode code blocks by allocating the same or similar maximum number of decoding iterations to each of the code blocks. That is, the receiving device may decode relatively quickly and easily by collectively allocating the same or similar maximum number of decoding iterations to the code blocks. However, efficient decoding may be difficult in certain channel environments.

SUMMARY

One or more embodiments provide a modem chip configured to allocate the maximum number of decoding iterations per code block so that decoding on the code blocks is efficiently performed in units of code blocks for error correction, and an electronic device including the modem chip.

Further, one or more embodiments provide a modem chip configured to measure qualities of resource elements based on resource element-to-code block (RE-CB) mapping patterns and allocate the maximum number of decoding iterations per code block, and an electronic device including the modem chip.

According to an aspect of the present disclosure, there is provided a method of operating a modem chip, the method including measuring quality of a plurality of resource elements allocated to receive a codeword, allocating a maximum number of decoding iterations per code block based on a measurement result of the quality and a resource element-to-code block (RE-CB) mapping pattern corresponding to a target slot, and decoding a plurality of first code blocks of the target slot based on the allocated maximum number of decoding iterations per code block.

According to another aspect of the present disclosure, there is provided a modem chip including memory and a processing circuit configured to access the internal memory to allocate a maximum number of decoding iterations per code block based on quality of the plurality of resource elements allocated to receive a codeword and a resource element-to-code block (RE-CB) mapping pattern corresponding to a target slot, and decode a plurality of first code blocks of the target slot based on the allocated maximum number of decoding iterations per code block.

According to another aspect of the present disclosure, there is provided a method of operating a modem chip, the method including decoding a plurality of first code blocks of a plurality of slots, measuring quality of a plurality of resource elements based on a result of decoding the plurality of first code blocks and a resource element to code block (RE-CB) mapping pattern corresponding to each of the plurality of slots, allocating, based on a measurement result of the plurality of resource elements, a maximum number of decoding iterations per code block, and decoding the plurality of first code blocks of a target slot based on the allocated maximum number of decoding iterations per code block.

The maximum number of decoding iterations per code block may comprise the maximum number of decoding iterations per code block of the codeword. The measurement result of the quality may comprise the measured quality of the plurality of resource elements allocated to receive the codeword. The method and modem chip may adaptively allocate the maximum number of decoding iterations per code block based on the measurement result of the plurality of resource elements and the RE-CB mapping pattern.

At least some of the above and other features of the disclosure are set out in the claims.

BRIEF DESCRIPTION OF DRAWINGS

Embodiments will be more clearly understood from the following detailed description taken in conjunction with the accompanying drawings in which:

FIG. 1 is a block diagram schematically showing an electronic device according to one or more embodiments;

FIG. 2A is a diagram showing a basic structure of a time-frequency domain, which is a radio resource region, FIG. 2B is a diagram showing a slot structure, and FIG. 2C is a diagram showing resource elements of a slot according to one or more embodiments;

FIG. 3 is a diagram showing a codeword according to one or more embodiments;

FIG. 4 is a block diagram showing in detail a decoding circuit according to one or more embodiments;

FIG. 5 is a flowchart illustrating a method of operating a decoding circuit, according to one or more embodiments;

FIG. 6 is a diagram illustrating a monitoring section according to one or more embodiments, and FIG. 7 is a flowchart illustrating a method of operating a decoding circuit and a quality measurement circuit in the monitoring section of FIG. 6;

FIG. 8A is a diagram showing an example of results of decoding of a monitoring section according to one or more embodiments, and FIG. 8B is a diagram showing a quality measurement method of resource elements according to the results of decoding of FIG. 8A;

FIG. 9 is a flowchart illustrating a specific embodiment of operation S110 of FIG. 5;

FIG. 10A is a diagram showing a target slot according to one or more embodiments, and FIG. 10B is a diagram showing a method of generating a measurement result representing a quality per code block in code blocks corresponding to the target slot of FIG. 10A;

FIG. 11 is a flowchart illustrating a specific embodiment of operation S112 of FIG. 9;

FIG. 12 is a diagram illustrating a method of allocating a maximum number of decoding iterations per code block on the basis of a weight that is set per code block according to one or more embodiments;

FIG. 13 is a flowchart illustrating a method of operating a decoding circuit and a quality measurement circuit in the monitoring section of FIG. 6;

FIG. 14 is a flowchart illustrating a method of operating a decoding circuit, according to one or more embodiments;

FIGS. 15A, 15B, 15C, and 15D illustrate a method of indirectly measuring quality of resource elements, according to one or more embodiments;

FIG. 16 is a flowchart illustrating a method of operating a decoding circuit, according to one or more embodiments;

FIG. 17 is a block diagram schematically showing a system-on-chip according to one or more embodiments;

FIG. 18 is a block diagram showing an electronic device according to one or more embodiments; and

FIG. 19 is a diagram showing communication devices configured to perform a decoding operation according to one or more embodiments.

DETAILED DESCRIPTION OF EMBODIMENTS

Embodiments are described below with reference to the drawings.

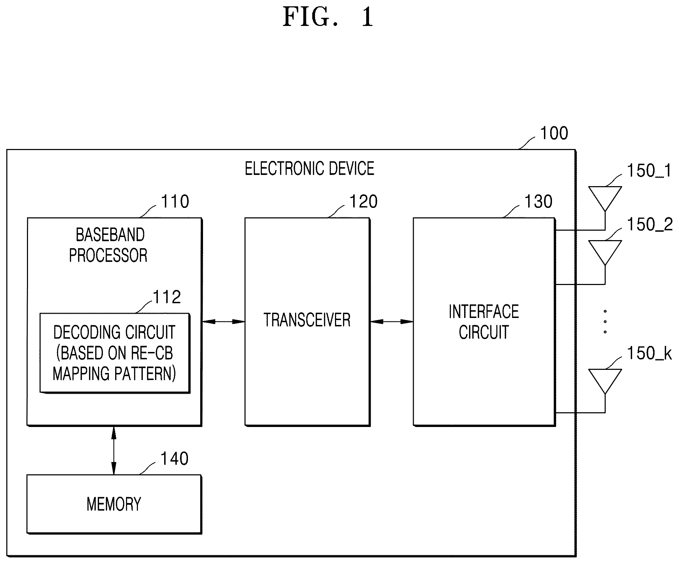

FIG. 1 is a block diagram schematically showing an electronic device 100 according to one or more embodiments.

Referring to FIG. 1, the electronic device 100 may include a baseband processor 110, a transceiver 120, an interface circuit 130, memory 140, and a plurality of antennas 150_1, 150_2, ..., and 150_k. In some embodiments, the electronic device 100 may be implemented or referred to as user equipment, a terminal, a mobile station (MS), a mobile terminal (MT), a user terminal (UT), a wireless communication device, a handheld device, or a wearable device.

For example, the electronic device 100 may communicate with another electronic device or a base station based on a new radio (NR) network. However, this is only an example, and the embodiments are not limited to the NR network. The embodiments may be applied to other wireless networks having similar technical backgrounds or channel settings (e.g., communication networks, such as long term evolution (LTE), LTE-advanced (LTE-A), wireless broadband (WiBro), global system for mobile communication (GSM), and sixth-generation (6G), or short-distance communication networks, such as Bluetooth and near field communication (NFC)).

In addition, various other functions described below may be implemented or supported by artificial intelligence (AI) technology or one or more computer programs, each of which may include computer-readable program code and be executed on a computer-readable medium. The terms "application" and "program" refer to one or more computer programs, software components, sets of instructions, procedures, functions, objects, classes, instances, associated data, or any part thereof suitable for implementing suitable computer-readable program code. The term "computer-readable program code" includes any type of computer code, including source code, object code, and executable code. The term "computer-readable media" includes any type of media that may be accessed by a computer, such as read-only memory (ROM), random-access memory (RAM), a hard disk drive, a compact disc (CD), a digital video disc (DVD), and any other type of memory. "Non-transitory" computer-readable media excludes wired, wireless, optical, or other communication links that transmit transitory electrical or other signals. The non-transitory computer-readable media includes media, on which data may be stored permanently, and media, on which data is stored and subsequently overwritten, such as rewritable optical discs and erasable memory devices.

In embodiments described below, a hardware approach is illustrated as an example. However, the embodiments include technology that uses both hardware and software, and thus, the embodiments do not exclude a software-based approach.

Referring back to FIG. 1, the interface circuit 130 may include a plurality of switches for connecting the transceiver 120 to the plurality of antennas 150_1, 150_2, ..., and 150_k according to an operation of the transceiver 120, a plurality of low-noise amplifiers for amplifying received signals, and a plurality of power amplifiers for amplifying signals to be transmitted.

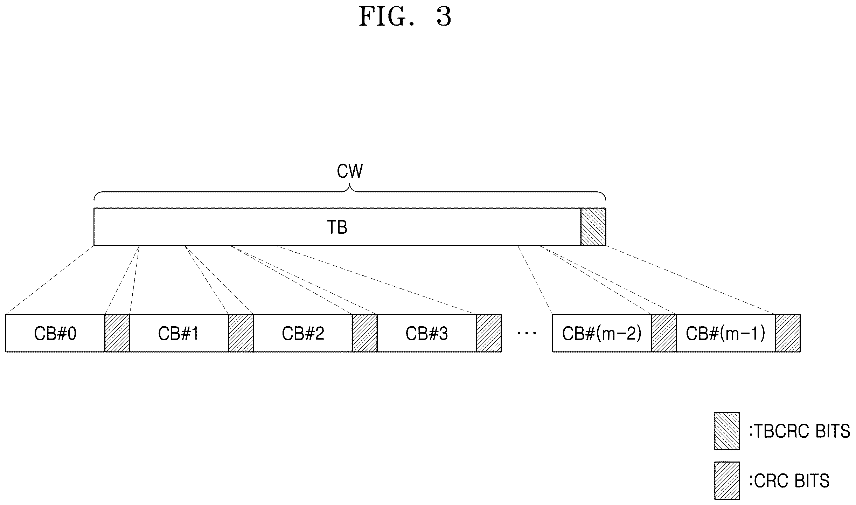

The transceiver 120 may receive radio frequency (RF) signals via the plurality of antennas 150_1, 150_2, ..., and 150_k. The transceiver 120 may perform frequency-down conversion on the received RF signals to generate intermediate frequency (IF) signals or baseband signals. The transceiver 120 may generate data by filtering or digitizing the IF signals or the baseband signals. Also, the data may include a plurality of code blocks as a codeword. This is described below in detail with reference to FIG. 3.

Also, the transceiver 120 may receive data from the baseband processor 110. The transceiver 120 may multiplex or analog-convert the received data to generate the IF signals or the baseband signals. The transceiver 120 may perform frequency-up conversion on the IF signals or the baseband signals and transmit the converted signals as RF signals to the base station or other electronic devices via the plurality of antennas 150_1, 150_2, ..., and 150_k.

The baseband processor 110 may perform operations for controlling all of the electronic device 100 or processing data for communication with the base station or other electronic devices. In addition, the baseband processor 110 may perform operations in conjunction with a processor (e.g., a central processing unit (CPU)) of the electronic device 100.

In one or more embodiments, the baseband processor 110 may include a decoding circuit 112 that performs decoding in units of code blocks for error correction with respect to a codeword received from the transceiver 120. For example, the decoding circuit 112 may perform decoding in units of code blocks based on a low density parity check (LDPC) technique or a turbo code technique. However, this is only an example and not limited thereto. The decoding circuit 112 may perform decoding in units of code blocks based on other techniques. As used herein, decoding for error correction of a code block may be referred to as decoding on the code block.

In one or more embodiments, the decoding circuit 112 may perform parallel or sequential decoding on a plurality of code blocks in a single codeword on the basis of a resource element-to-code block (RE-CB) mapping pattern. As used herein, the RE-CB mapping pattern may be defined as a mapping pattern between code blocks constituting a codeword and resource elements forming a slot corresponding to the codeword, in a time-frequency grid associated with the codeword. The RE-CB mapping pattern may also be referred to as RE-CB mapping or RE-CB mapping information. The operation of decoding based on the RE-CB mapping pattern may include at least one of an operation of measuring the quality of resource elements based on the RE-CB mapping pattern described below and an operation of allocating the maximum number of decoding iterations per code block based on the RE-CB mapping pattern described below.

In one or more embodiments, prior to decoding a target slot, the decoding circuit 112 may measure the quality of a plurality of resource elements that are used as a basis for allocating the maximum number of decoding iterations per code block, which is described below. The plurality of resource elements may include radio resources allocated for communication of the electronic device 100, and may form a channel for transmitting the codeword including the plurality of code blocks. As used herein, the target slot may be defined as a slot corresponding to a target codeword currently subject to decoding.

In one or more embodiments, the decoding circuit 112 may measure the quality of the plurality of resource elements on the basis of results of decoding on the plurality of code blocks corresponding to a monitoring section preceding the target slot. As used herein, a monitoring section may be defined as a configurable time interval, such as a group of contiguous or non-contiguous slots that are used for measuring the quality of the plurality of resource elements. For example, the monitoring section may include a plurality of slots, and the number of slots included in the monitoring section may be static or dynamically adjustable based on system configuration or channel conditions. A plurality of codewords corresponding to the plurality of slots in the monitoring section may include the plurality of code blocks, and may have the same or different RE-CB mapping patterns. The decoding circuit 112 may decode the plurality of code blocks of the codewords in the monitoring section, and may measure the quality of the plurality of resource elements on the basis of the result of decoding and the RE-CB mapping pattern. For example, the results of decoding may include, but are not limited to: a result on whether decoding has failed for the plurality of code blocks, and a result on whether decoding has been terminated early for the plurality of code blocks (e.g., whether the decoding of the plurality of code blocks has completed prior to reaching their respective maximum number of decoding iterations). That is, the decoding circuit 112 may numerically quantify the results of decoding per code block as quality per resource element on the basis of the RE-CB mapping pattern, thereby measuring the quality per resource element.

As described above, in addition to the embodiment of measuring the quality of the plurality of resource elements, there may be another embodiment in which the quality of the plurality of resource elements is indirectly measured, which is described below.

In one or more embodiments, prior to decoding the target slot, the decoding circuit 112 may indirectly measure the quality of the plurality of resource elements that are used as a basis for allocating the maximum number of decoding iterations per code block, which is described below. As used herein, an indirect measuring operation may be understood as a predicting operation. In one or more embodiments, the decoding circuit 112 may collect information about the quality of the plurality of resource elements and indirectly measure the quality of the plurality of resource elements on the basis of the collected information. For example, the information may include at least one of first information about a center frequency (a center carrier) (e.g., the center frequency of the allocated bandwidth, which may impact channel conditions due to frequency-dependent fading), second information about a slot that changes from uplink to downlink (e.g., information specifying whether a given slot transitions between uplink and downlink, which may influence interference levels and signal reliability), third information about a resource element located at an edge on the basis of a frequency axis (e.g., information identifying resource elements located near the spectral edges where signal degradation may occur), and fourth information about an arrangement of a demodulation reference signal (DMRS) (e.g., the configuration or placement of the DMRS, which may affect the accuracy of channel estimation across the frequency-time grid). However, this is only an example and the embodiment is not limited thereto. The quality of the plurality of resource elements may be indirectly measured by using more information about a factor that may affect the quality of at least one specific resource element.

In one or more embodiments, the decoding circuit 112 may allocate the maximum number of decoding iterations per code block in order to decode the plurality of code blocks in the codeword corresponding to the target slot. That is, the decoding circuit 112 may individually allocate the maximum number of decoding iterations appropriate for each of the plurality of code blocks. As used herein, the maximum number of decoding iterations represents the maximum number of iterations that may be performed until the code block is successfully decoded (e.g., an upper limit of attempts allowed to successfully decode a given code block). For example, when a code block is allocated a maximum of 10 decoding iterations, decoding may be repeatedly attempted up to 10 times until decoding is successfully performed on the code block. However, when decoding fails after all 10 iterations, it may be finally determined that decoding has failed for the code block. Also, when the decoding is successfully completed for the code block before 10 iterations, an iteration may be terminated and it may be determined that the decoding on the code block has been successfully completed.

In one or more embodiments, the decoding circuit 112 may allocate the maximum number of decoding iterations appropriate for each of the plurality of code blocks of the codeword corresponding to the target slot on the basis of the quality of the plurality of resource elements and the RE-CB mapping pattern corresponding to the target slot. In a specific example, the decoding circuit 112 may check the quality of code blocks in the target slot on the basis of the quality of the plurality of resource elements and the RE-CB mapping pattern corresponding to the target slot, and may allocate the maximum number of decoding iterations per code block in a certain manner according to the checked quality of the code blocks. For example, the decoding circuit 112 may allocate a smaller maximum number of decoding iterations to a code block identified as having good quality, and may allocate a larger maximum number of decoding iterations to a code block identified as having poor quality. For example, the decoding circuit 112 may set an upper limit or a lower limit on the maximum number of decoding iterations and allocate the maximum number of decoding iterations per code block within the set range. For example, when the quality of a code block is confirmed as very poor, the decoding circuit 112 may allocate a very small maximum number of decoding iterations and thus minimize the number of decoding iterations on a code block for which a decoding failure is clearly expected. Also, for example, the decoding circuit 112 may be configured to ensure that the maximum number of decoding iterations allocated to a code block that has been identified as having the worst quality is different from, by no more than a threshold, the maximum number of decoding iterations allocated to a code block that has been identified as having the best quality. In other words, the decoding circuit 112 may be configured to limit a difference in allocated decoding iterations between the highest-quality and lowest-quality code blocks to a predefined threshold.

In some embodiments, the decoding circuit 112 may also allocate the maximum number of decoding iterations appropriate for each of the plurality of code blocks of the codeword corresponding to the target slot on the basis of factors other than the quality of the plurality of resource elements. For example, the decoding circuit 112 may adaptively allocate the maximum number of decoding iterations per code block according to changes or features of a channel by using a neural network model that has been constructed and trained.

In one or more embodiments, the decoding circuit 112 may use memory 140 in decoding the code blocks.

In one or more embodiments, the baseband processor 110 and the memory 140 may be integrated into a modem chip. In some embodiments, the transceiver 120 and the interface circuit 130 may be integrated into an RF chip, and the modem chip and the RF chip may be integrated into a system on chip.

As used herein, the decoding circuit 112 may be implemented as hardware exclusively performing operations according to embodiments, implemented as software that is a set of pieces of code or commands executed by the baseband processor 110, or implemented as a combination of hardware and software. Accordingly, the operation of the decoding circuit 112 may be understood as the operation of the baseband processor 110, the modem chip, or the electronic device 100.

The decoding circuit 112 according to one or more embodiments may allocate the maximum number of decoding iterations per code block on the basis of the quality of the plurality of resource elements, thereby efficiently performing the decoding operation. As a result, the decoding performance of the decoding circuit 112 may be improved, and resources of the decoding circuit 112 may be used efficiently.

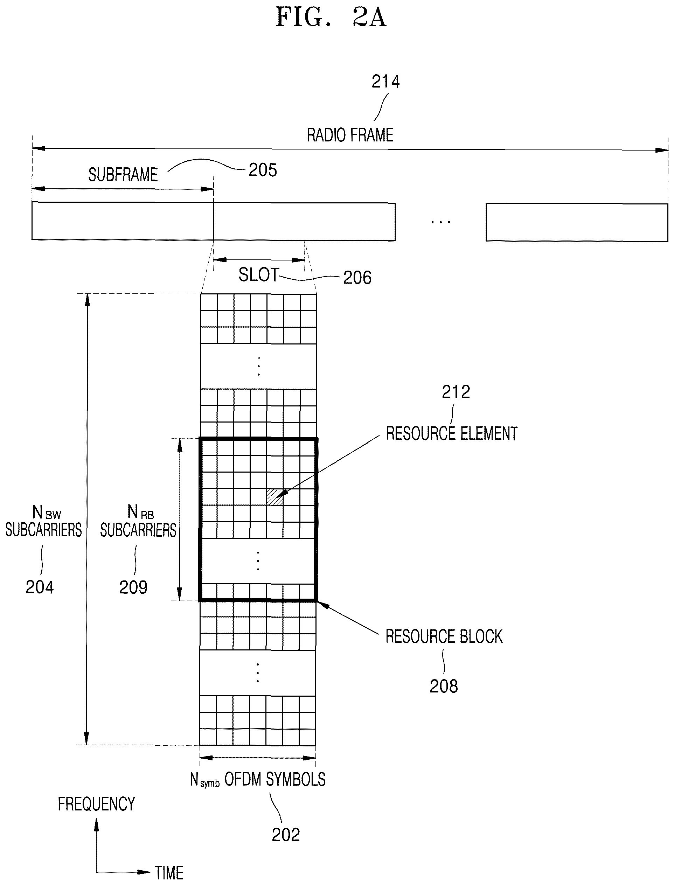

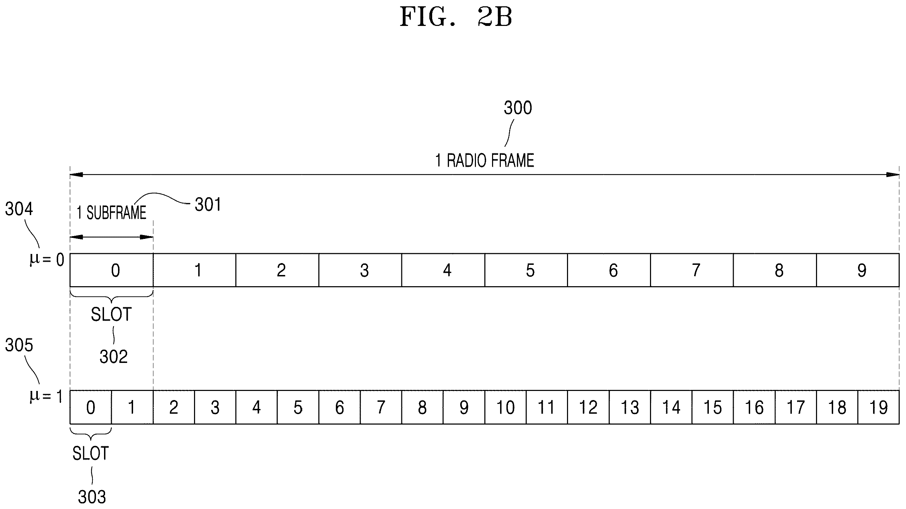

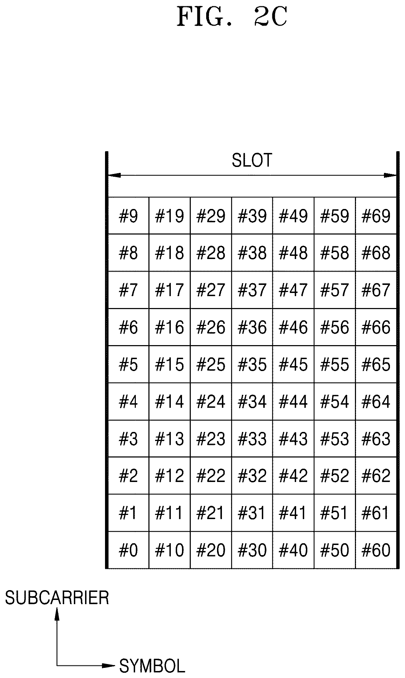

FIG. 2A is a diagram showing a basic structure of a time-frequency domain, which is a radio resource region, FIG. 2B is a diagram showing a slot structure, and FIG. 2C is a diagram showing resource elements of a slot.

Referring to FIG. 2A, the horizontal axis may represent a time domain (or a symbol domain) and the vertical axis may represent a frequency domain (or a subcarrier domain). A minimum transmission unit in the time domain is an orthogonal frequency division multiplexing (OFDM) symbol, and $N_{SYMB}$-OFDM symbols 202 may be gathered to form a single slot 206. Two slots may be gathered to form a single subframe 205. For example, the length of the slot 206 may be 0.5 ms, and the length of the subframe 205 may be 1.0 ms. However, this is an example. The length of the slot 206 may vary depending on the configuration of the slot 206, and the number of slots 206 in the subframe 205 may vary depending on the length of the slot 206. Also, in the NR network, the time-frequency domain may be defined based on the slot 206. In addition, a radio frame 214 may be a unit of the time domain including ten subframes 205.

The minimum transmission unit in the frequency domain is a subcarrier, and the width of the entire system transmission bandwidth may include a total of $N_{BW}$-subcarriers 204. In the time-frequency domain, the basic unit of a resource is a resource element 212, which may be represented by an OFDM symbol index and a subcarrier index. A resource block 208 may be defined as consecutive $N_{SYMB}$-OFDM symbols 202 in the time domain and consecutive $N_{RB}$-subcarriers 209 in the frequency domain. Therefore, one resource block 208 may include ($N_{SYMB}$ * $N_{RB}$) of resource elements 212. A pair of resource blocks is a unit of two resource blocks connected to each other in the time axis and may include ($N_{SYMB}$ * $2N_{RB}$) of resource elements 212.

Also, the electronic device 100 may communicate with the base station or another electronic device via radio resources in the time-frequency domain, such as in FIG. 2A. For example, the electronic device 100 may allocate the maximum number of decoding iterations per code block on the basis of the quality of the resource elements 212.

Referring further to FIG. 2B, one radio frame 300 may have a duration of 10 ms, a subframe 301 may have a duration of 1 ms, and the radio frame 300 may include a total of 10 subframes 301. Each of slots 302 and 303 may include 14 OFDM symbols (i.e., the number of symbols per slot ($N_{symb}^{slot}$)=14). One subframe 301 may include one or more slots 302 and 303, and the number of slots 302 and 303 per subframe 301 may vary depending on setting values ($\mu$) 304 and 305 with respect to subcarrier spacing and the number of symbols included in the slots 302 and 303. FIG. 2B illustrates a case in which the subcarrier spacing setting values are $\mu = 0$ (304) and $\mu = 1$ (305). When the subcarrier spacing setting value is $\mu = 0$ (304), one subframe 301 may include one slot 302. Also, when the subcarrier spacing setting value is $\mu = 1$ (305), one subframe 301 may include two slots 303.

As described above, the number of slots per subframe may vary depending on the setting value ($\mu$) for subcarrier spacing, and accordingly, the number of slots per radio frame may vary. The number of slots per one subframe ($N_{slot}^{subframe,\mu}$) and the number of slots per one frame ($N_{slot}^{frame,\mu}$) according to the setting value ($\mu$) for each subcarrier spacing may be defined in [Table 1].

[Table 1]

| $\mu$ | $N_{symb}^{slot}$ | $N_{slot}^{frame,\mu}$ | $N_{slot}^{subframe,\mu}$ |
|---|---|---|---|
| 0 | 14 | 10 | 1 |
| 1 | 14 | 20 | 2 |
| 2 | 14 | 40 | 4 |
| 3 | 14 | 80 | 8 |

(continued)

| $\mu$ | $N_{symb}^{slot}$ | $N_{slot}^{frame,\mu}$ | $N_{slot}^{subframe,\mu}$ |
|---|---|---|---|
| 4 | 14 | 160 | 16 |

Also, in some embodiments, the number of slots per subframe may vary depending on the number of symbols included in a single slot. For example, the setting value ($\mu$) may have any one of values '0, 1, 2, 3, and 4', and these values may represent '15 kHz, 30 kHz, 60 kHz, 120 kHz, and 240 kHz', respectively.

The slots 302 and 303 may have different lengths depending on the setting values ($\mu$) for the respective subcarrier spacings, and the embodiment may be applied to the slots 302 and 303.

Referring to FIG. 2C, the horizontal axis may represent a symbol domain (or a time domain), and the vertical axis may represent a subcarrier domain (or a frequency domain). A slot SLOT has a configuration including seven symbols, and the 1st to 70th resource elements #0 to #69 may be mapped to the slot SLOT. A codeword corresponding to a specific primary carrier and a specific hybrid automatic repeat request (HARQ) ID may be arranged in the slot SLOT. The code blocks of the corresponding codeword are mapped to the 1st to 70th resource elements #0 to #69, and the corresponding codeword may be transmitted via the 1st to 70th resource elements #0 to #69. That is, the corresponding codeword may be transmitted via a radio resource including seven consecutive symbols in the symbol domain and ten consecutive subcarriers in the subcarrier domain.

FIG. 3 is a diagram showing a codeword CW according to one or more embodiments.

Referring to FIG. 3, the codeword CW may include a transport block TB and transport block cyclic redundancy check (TBCRC) bits that are appended at the end of the transport block TB to determine whether the transport block TB has been successfully decoded by a receiving side (or a receiving device). Also, the codeword CW may include first to mth code blocks CB#0 to CB#(m-1). Each of the first to mth code blocks CB#0 to CB#(m-1) may include CRC bits that are appended at the end of the code block to determine whether the code block has been successfully decoded by the receiving side (or the receiving device). The code blocks CB#0 to CB#(m-1) may be within the transport block TB and TBCRC bits.

In one or more embodiments, the decoding circuit 112 of FIG. 1 may allocate the maximum number of decoding iterations individually suitable for each of the first to mth code blocks CB#0 to CB#(m-1) on the basis of the quality of the resource elements on which the codeword CW is located.

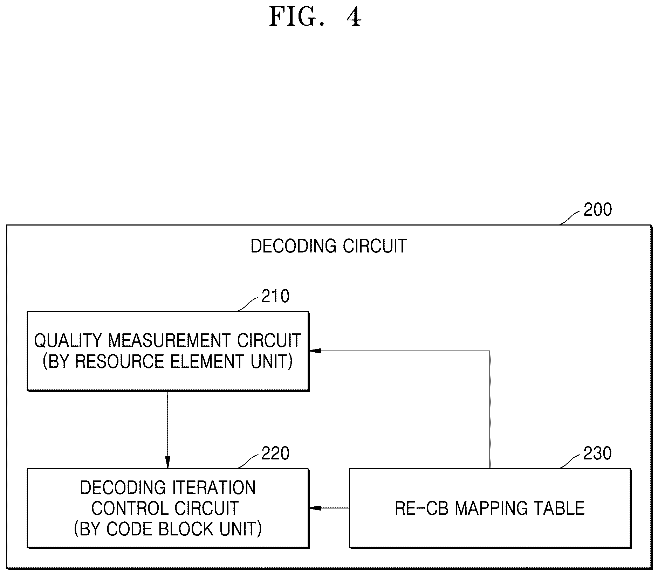

FIG. 4 is a block diagram showing in detail a decoding circuit 200 according to one or more embodiments.

Referring to FIG. 4, the decoding circuit 200 may include a quality measurement circuit 210, a decoding iteration control circuit 220, and an RE-CB mapping table 230.

In one or more embodiments, the quality measurement circuit 210 may measure the quality in units of resource elements. For example, the quality measurement circuit 210 may measure the quality of resource elements on the basis of the results of decoding on the plurality of code blocks corresponding to the monitoring section. In a specific example, the results of decoding may include at least one of a result on whether decoding has failed for the plurality of code blocks and a result on whether decoding has been terminated early for the plurality of code blocks. The quality measurement circuit 210 may convert the results of decoding in units of code blocks to the results in units of resource elements with reference to the RE-CB mapping table 230 and then numerically quantify the converted results to measure the quality per resource element. Also, for example, the quality measurement circuit 210 may indirectly measure the quality of the plurality of resource elements on the basis of information associated with the quality of the plurality of resource elements. In a specific example, the quality measurement circuit 210 may indirectly measure the quality of the plurality of resource elements on the basis of at least one of the first information about the center frequency, the second information about the slot that changes from uplink to downlink, the third information about the resource element located at the edge on the basis of the frequency axis, and the fourth information about the arrangement of the DMRS. In some embodiments, the quality measurement circuit 210 may measure the quality of the plurality of resource elements by using both the direct measurement method and the indirect measurement method described above.

In one or more embodiments, the decoding iteration control circuit 220 may allocate the maximum number of decoding iterations per code block on the basis of the quality of the plurality of resource elements measured by the quality measurement circuit 210. For example, the decoding iteration control circuit 220 may refer to the RE-CB mapping pattern of the plurality of code blocks corresponding to the target slot from the RE-CB mapping table 230, and may check the quality of the plurality of code blocks corresponding to the target slot on the basis of the referenced RE-CB mapping pattern and the quality of the plurality of resource elements. The decoding iteration control circuit 220 may allocate the maximum number of decoding iterations per code block on the basis of the checked quality of the plurality of code blocks. For example, the decoding iteration control circuit 220 may set a weight per code block defined by a certain equation and allocate the maximum number of decoding iterations per code block on the basis of the results of the setting. For example, the certain equation may be designed to ensure stable execution of decoding by setting an upper limit or a lower limit on the maximum number of decoding iterations or by limiting the difference in the maximum number of decoding iterations between code blocks to be less than a threshold.

Also, the configurations of the decoding circuit 200 in FIG. 4 are only examples illustrating the embodiments. Therefore, the embodiment is not limited thereto, and the decoding circuit 200 may be formed in other configurations. In addition, the operations of the quality measurement circuit 210 and the decoding iteration control circuit 220 may be understood as the operation of the decoding circuit 200.

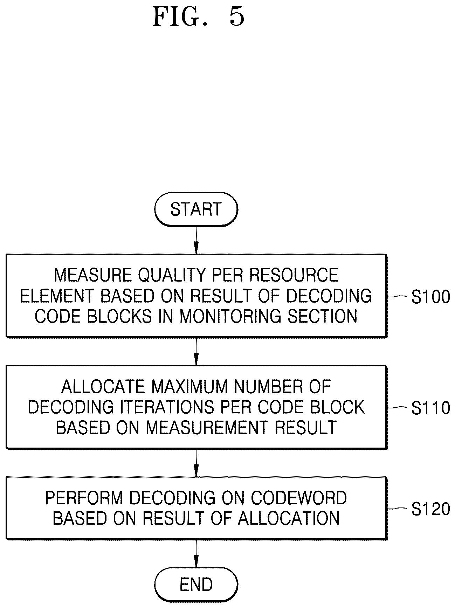

FIG. 5 is a flowchart illustrating a method of operating a decoding circuit, according to one or more embodiments. Also, the operation of the decoding circuit in FIG. 5 may be understood as the operation of a baseband processor, a modem chip, or an electronic device that includes the decoding circuit.

Referring to FIG. 5, in operation S100, the decoding circuit may measure the quality per resource element on the basis of the results of decoding for code blocks in the monitoring section. For example, the decoding circuit may convert the results of decoding per code block into the results of decoding per resource element on the basis of the RE-CB mapping pattern of code blocks in the monitoring section, and then numerically quantify the converted results to measure the quality per resource element.

In operation S110, the decoding circuit may allocate the maximum number of decoding iterations per code block on the basis of the measurement results in operation S100. For example, the decoding circuit may check the quality per code block corresponding to the target slot from the quality per resource element included in the measurement results on the basis of the RE-CB mapping pattern corresponding to the target slot (or the RE-CB mapping pattern corresponding to the codeword located in the target slot). The decoding circuit may allocate the maximum number of decoding iterations per code block on the basis of the quality per identified code block.

Also, in operation S120, the decoding circuit may decode the codeword located in the target slot on the basis of the results of allocation in operation S110. For example, the decoding circuit may decode per code block on the basis of the maximum number of decoding iterations allocated for each of the plurality of code blocks of the codeword located in the target slot. When successfully decoding in units of code blocks, the decoding circuit may determine, based on the TBCRC bits in FIG. 3, whether the transport block of the codeword has been successfully decoded.

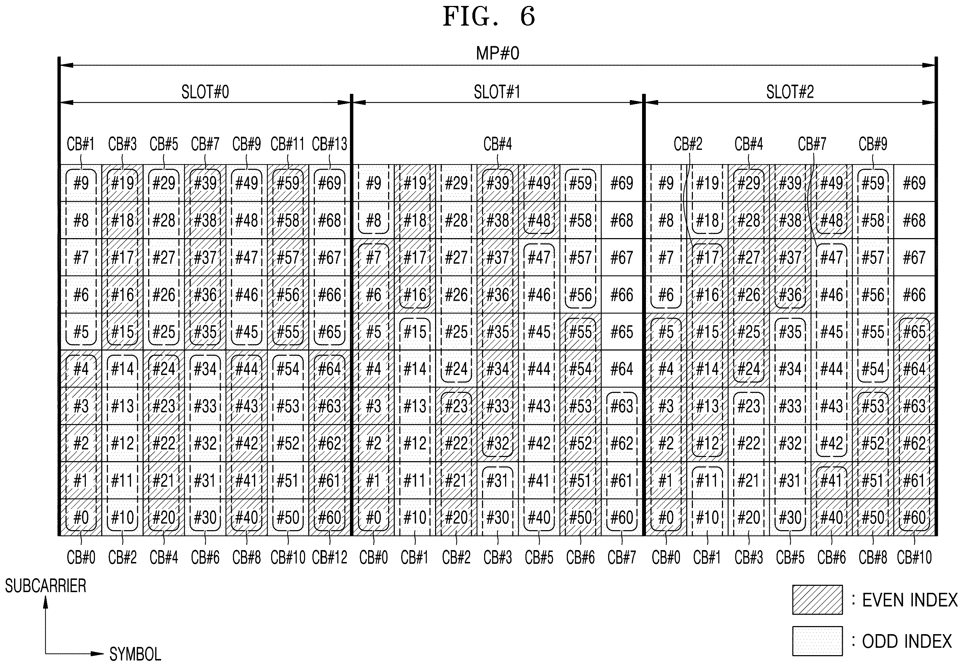

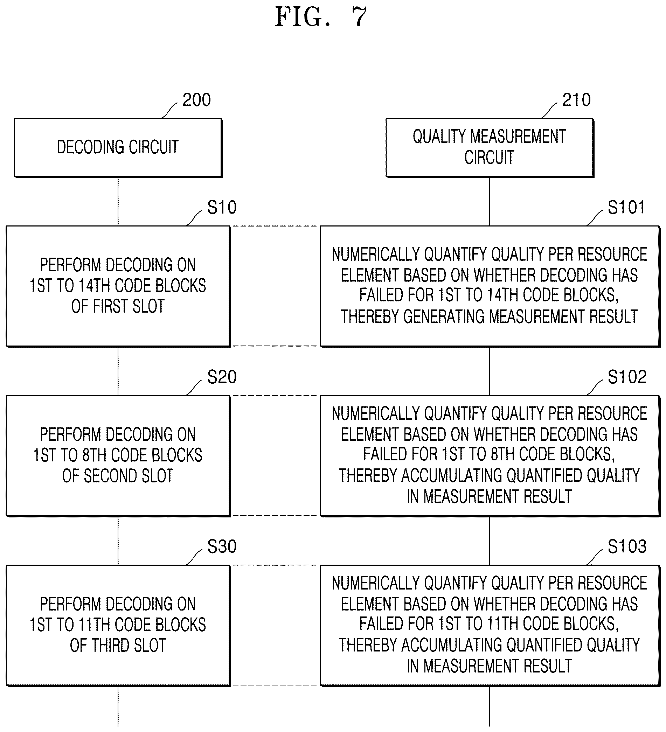

FIG. 6 is a diagram illustrating a monitoring section MP#0 according to one or more embodiments, and FIG. 7 is a flowchart illustrating a method of operating the decoding circuit 200 and the quality measurement circuit 210 in the monitoring section MP#0 of FIG. 6. FIG. 7 shows a specific embodiment of operation S100 of FIG. 5.

Referring to FIG. 6, the monitoring section MP#0 may include first to third slots SLOT#0, SLOT#1, and SLOT#2. The monitoring section MP#0 may be preset to include three slots, and the length of the monitoring section MP#0 varies.

A first codeword located in the first slot SLOT#0 may include the 1st to 14th code blocks CB#0 to CB#13, a second codeword located in the second slot SLOT#1 may include the 1st to 8th code blocks CB#0 to CB#7, and a third codeword located in the third slot SLOT#2 may include the 1st to 11th code blocks CB#0 to CB#10. The first codeword may have a first RE-CB mapping pattern corresponding to a first HARQ ID, the second codeword may have a second RE-CB mapping pattern corresponding to a second HARQ ID, and the third codeword may have a third RE-CB mapping pattern corresponding to a third HARQ ID. Also, it is assumed that the first to third codewords correspond to the same primary carrier.

In the first codeword of the first slot SLOT#0, according to the first RE-CB mapping pattern, the 1st code block CB#0 may be mapped to the 1st to 5th resource elements #0 to #4, the 2nd code block CB#1 may be mapped to the 6th to 10th resource elements #5 to #9, the 3rd code block CB#2 may be mapped to the 11th to 15th resource elements #10 to #14, the 4th code block CB#3 may be mapped to the 16th to 20th resource elements #15 to #19, the 5th code block CB#4 may be mapped to the 21st to 25th resource elements #20 to #24, the 6th code block CB#5 may be mapped to the 26th to 30th resource elements #25 to #29, the 7th code block CB#6 may be mapped to the 31st to 35th resource elements #30 to #34, the 8th code block CB#7 may be mapped to the 36th to 40th resource elements #35 to #39, the 9th code block CB#8 may be mapped to the 41st to 45th resource elements #40 to #44, the 10th code block CB#9 may be mapped to the 46th to 50th resource elements #45 to #49, the 11th code block CB#10 may be mapped to the 51st to 55th resource elements #50 to #54, the 12th code block CB#11 may be mapped to the 56th to 60th resource elements #55 to #59, the 13th code block CB#12 may be mapped to the 61st to 65th resource elements #60 to #64, and the 14th code block CB#13 may be mapped to the 66th to 70th resource elements #65 to #69.

In the second codeword of the second slot SLOT#1, according to the second RE-CB mapping pattern, the 1st code block CB#0 may be mapped to the 1st to 8th resource elements #0 to #7, the 2nd code block CB#1 may be mapped to the 9th to 16th resource elements #8 to #15, the 3rd code block CB#2 may be mapped to the 17th to 24th resource elements #16 to #23, the 4th code block CB#3 may be mapped to the 25th to 32nd resource elements #24 to #31, the 5th code block CB#4 may be mapped to the 33rd to 40th resource elements #32 to #39, the 6th code block CB#5 may be mapped to the 41st to 48th resource elements #40 to #47, the 7th code block CB#6 may be mapped to the 49th to 56th resource elements #48 to #55, and the 8th code block CB#7 may be mapped to the 57th to 64th resource elements #56 to #63.

In addition, in the third codeword of the third slot SLOT#2, according to the third RE-CB mapping pattern, the 1st code block CB#0 may be mapped to the 1st to 6th resource elements #0 to #5, the 2nd code block CB#1 may be mapped to the 7th to 12th resource elements #6 to #11, the 3rd code block CB#2 may be mapped to the 13th to 18th resource elements #12 to #17, the 4th code block CB#3 may be mapped to the 19th to 24th resource elements #18 to #23, the 5th code block CB#4 may be mapped to the 25th to 30th resource elements #24 to #29, the 6th code block CB#5 may be mapped to the 31st to 36th resource elements #30 to #35, the 7th code block CB#6 may be mapped to the 37th to 42nd resource elements #36 to #41, the 8th code block CB#7 may be mapped to the 43rd to 48th resource elements #42 to #47, the 9th code block CB#8 may be mapped to the 49th to 54th resource elements #48 to #53, the 10th code block CB#9 may be mapped to the 55th to 60th resource elements #54 to #59, and the 11th code block CB#10 may be mapped to the 61st to 66th resource elements #60 to #65.

Referring further to FIG. 7, in operation S10, the decoding circuit 200 may decode the 1st to 14th code blocks CB#0 to CB#13 in the first slot SLOT#0. For example, the decoding circuit 200 may sequentially perform decoding operations for error correction per code block on the 1st to 14th code blocks CB#0 to CB#13.

In operation S101, the quality measurement circuit 210 may generate the measurement results by numerically quantifying the quality per resource element on the basis of whether or not decoding failure occurred for the 1st to 14th code blocks CB#0 to CB#13 that have been identified in operation S10. In a specific example, the quality measurement circuit 210 may identify resource elements that are mapped to a code block that has failed to be decoded among the 1st to 14th code blocks CB#0 to CB#13 on the basis of the first RE-CB mapping pattern, and may generate the measurement results by using the numerically quantified value according to the decoding failure for each of the identified resource elements.

Also, when a code block has failed to be decoded in the first slot SLOT#0, the decoding circuit 200 may request a retransmission of the code block to the base station or another electronic device.

In operation S20, the decoding circuit 200 may decode the 1st to 8th code blocks CB#0 to CB#7 of the second slot SLOT#1. For example, the decoding circuit 200 may sequentially perform decoding operations for error correction per code block on the 1st to 8th code blocks CB#0 to CB#7.

In operation S102, the quality measurement circuit 210 may numerically quantify the quality per resource element on the basis of whether or not decoding failure occurred for the 1st to 8th code blocks CB#0 to CB#7 that have been identified in operation S20, and may accumulate the numerically quantified quality in the measurement results. In a specific example, the quality measurement circuit 210 may identify resource elements that are mapped to a code block that failed to be decoded among the 1st to 8th code blocks CB#0 to CB#7 on the basis of the second RE-CB mapping pattern, and may accumulate (or update) the measurement results by using the numerically quantified value according to the decoding failure for each of the identified resource elements. Also, when a code block has failed to be decoded in the second slot SLOT#1, the decoding circuit 200 may request a retransmission of the code block to the base station or another electronic device.

In operation S30, the decoding circuit 200 may decode the 1st to 11th code blocks CB#0 to CB#10 of the third slot SLOT#2. For example, the decoding circuit 200 may sequentially perform decoding operations for error correction per code block on the 1st to 11th code blocks CB#0 to CB#10.

In operation S103, the quality measurement circuit 210 may numerically quantify the quality per resource element on the basis of whether or not decoding failure occurred for the 1st to 11th code blocks CB#0 to CB#10 that have been identified in operation S30, and may accumulate the numerically quantified quality in the measurement results. In a specific example, the quality measurement circuit 210 may identify resource elements that are mapped to a code block that failed to be decoded among the 1st to 11th code blocks CB#0 to CB#10 on the basis of the third RE-CB mapping pattern, and may accumulate (or update) the measurement results by using the numerically quantified value according to the decoding failure for each of the identified resource elements. Also, when a code block has failed to be decoded in the third slot SLOT#2, the decoding circuit 200 may request a retransmission of the code block to the base station or another electronic device.

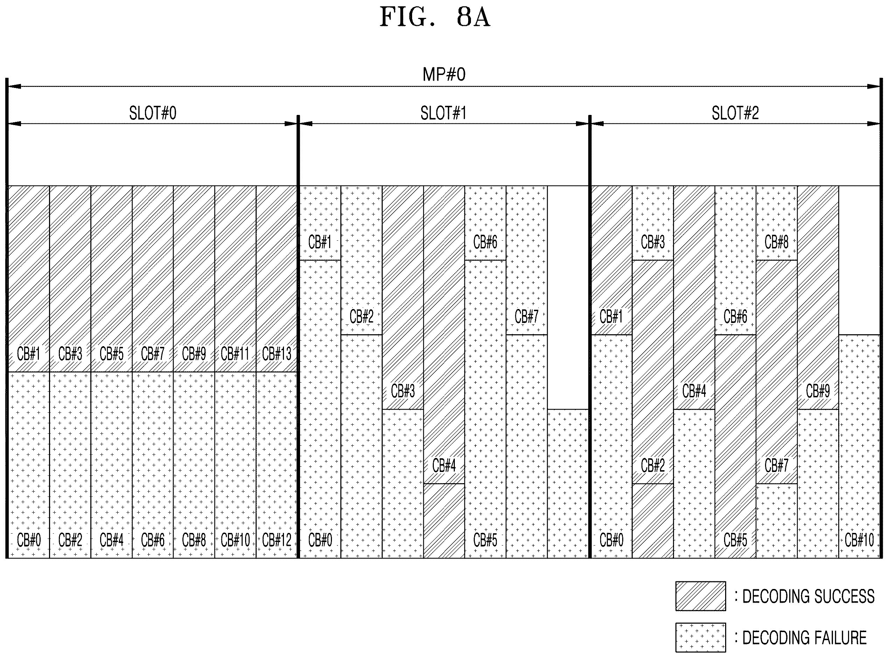

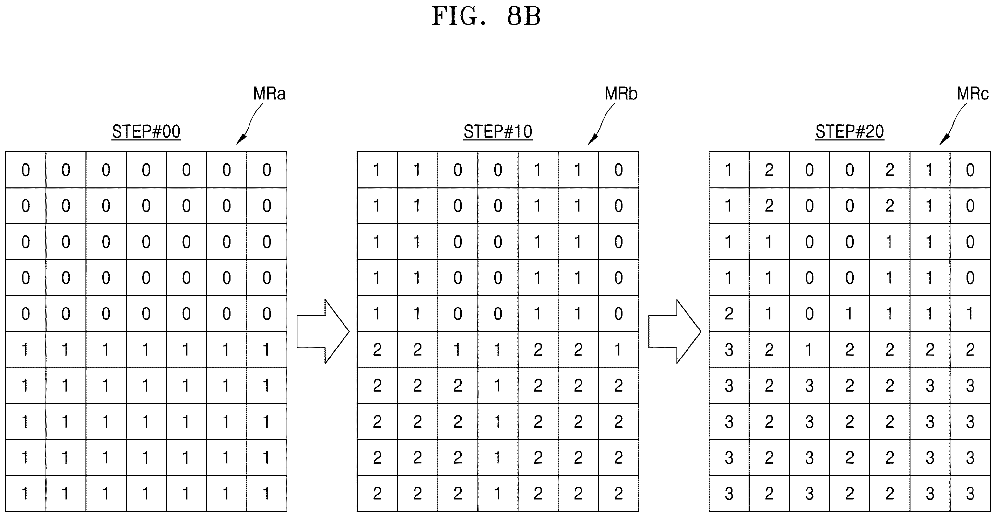

FIG. 8A is a diagram showing an example of the results of decoding of the monitoring section MP#0 according to one or more embodiments, and FIG. 8B is a diagram showing a quality measurement method of resource elements according to the results of decoding of FIG. 8A. Also, it is assumed that the measurement results MRa, MRb, and MRc in FIG. 8B correspond to the 1st to 69th resource elements #0 to #68 in FIG. 6.

Referring to FIG. 8A, in the first slot SLOT#0, the 1st code block CB#0, the 3rd code block CB#2, the 5th code block CB#4, the 7th code block CB#6, the 9th code block CB#8, the 11th code block CB#10, and the 13th code block CB#12 may be determined to have failed decoding. Also, the remaining code blocks (CB#1, CB#3, CB#5, CB#7, CB#9, CB#11, and CB#13) may be determined to have been successfully decoded.

In the second slot SLOT#1, the 1st code block CB#0, the 2nd code block CB#1, the 3rd code block CB#2, the 6th code block CB#5, the 7th code block CB#6 and the 8th code block CB#7 may be determined to have failed decoding. Also, the remaining code blocks (CB#3 and CB#4) may be determined to have been successfully decoded.

In addition, in the third slot SLOT#2, the 1st code block CB#0, 4th code block CB#3, 7th code block CB#6, 9th code block CB#8, and 11th code block CB#10 may be determined to have failed decoding. Also, the remaining code blocks (CB#1, CB#2, CB#4, CB#5, CB#7, and CB#9) may be determined to have been successfully decoded.

Referring further to FIG. 8B, in a first operation STEP#00, based on the results of decoding of the first slot SLOT#0 and the first RE-CB mapping pattern, the quality measurement circuit 210 (FIG. 7) may apply the value of '1,' which is numerically quantified to represent a decoding failure, to the resource elements (#0-#4, #10-#14, #20-#24, #30-#34, #40-#44, #50-#54, and #60-#64) mapped to code blocks that failed in decoding (CB#0, CB#2, CB#4, CB#6, CB#8, CB#10, and CB#12), thereby generating the measurement results MRa.

In a second operation STEP#10, based on the results of decoding of the second slot SLOT#1 and the second RE-CB mapping pattern, the quality measurement circuit 210 (FIG. 7) may accumulate the value of '1,' which is numerically quantified to represent a decoding failure, in the resource elements (#0-#7, #8-#15, #16-#23, #40-#47, #48-#55, and #56-#63) mapped to the code blocks that failed in decoding (CB#0, CB#1, CB#2, CB#5, CB#6, and CB#7), thereby updating the measurement results MRb.

In addition, in a third operation STEP#20, based on the results of decoding of the third slot SLOT#2 and the third RE-CB mapping pattern, the quality measurement circuit 210 (FIG. 7) may accumulate the value of '1,' which is numerically quantified to represent a decoding failure, in the code blocks that failed in decoding (CB#0, CB#3, CB#6, CB#8, and CB#10), thereby updating the measurement results MRc.

The quality measurement circuit 210 (FIG. 7) may measure the quality of the 1st to 70th resource elements #0 to #69 on the basis of the results of decoding on the plurality of code blocks (CB#0-CB#13, CB#0-CB#7, and CB#0-CB#10) in the monitoring section MP#0 and then provide the decoding iteration control circuit 220 (FIG. 7) with the generated measurement result MRc.

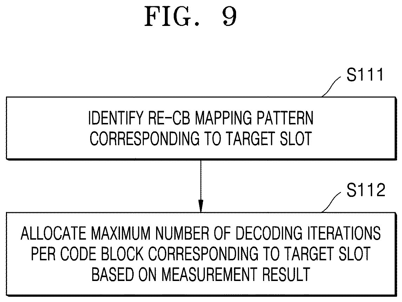

FIG. 9 is a flowchart illustrating a specific embodiment of operation S110 of FIG. 5.

Referring to FIG. 9, in operation S111, the decoding circuit may identify the RE-CB mapping pattern corresponding to the target slot. For example, the decoding circuit may obtain, from the RE-CB mapping table 230 (FIG. 4), the RE-CB mapping pattern conforming to the HARQ ID of the code block located in the target slot.

In operation S112, the decoding circuit may allocate the maximum number of decoding iterations per code block corresponding to the target slot on the basis of the measurement results in operation S100 of FIG. 5. For example, the decoding circuit may check the quality per code block on the basis of the RE-CB mapping pattern of the code blocks located in the target slot and the measurement results, and may allocate the maximum number of decoding iterations per code block on the basis of the quality per code block.

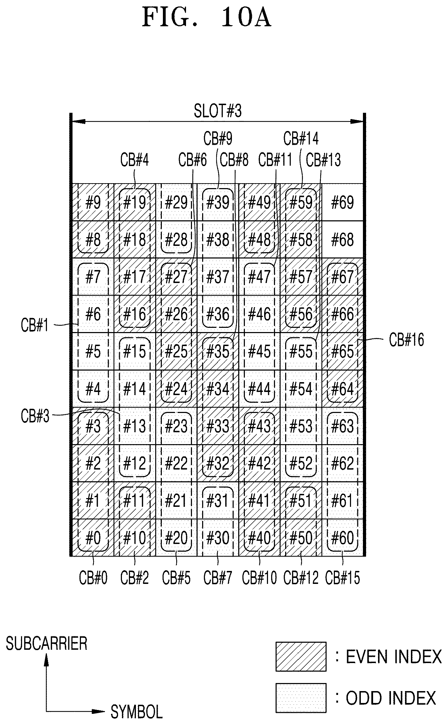

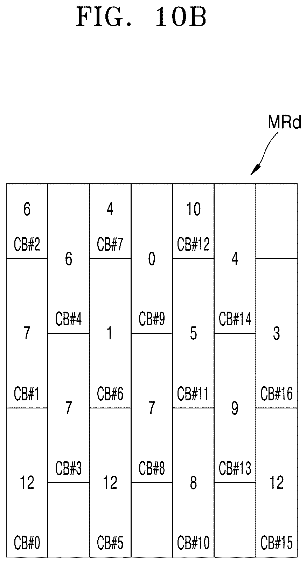

FIG. 10A is a diagram showing a target slot SLOT#3 according to one or more embodiments, and FIG. 10B is a diagram showing a method of generating a measurement result MRd representing the quality per code block in the 1st to 14th code blocks CB#0 to CB#13 corresponding to the target slot SLOT#3 of FIG. 10A. It is assumed that the target slot SLOT#3 in FIG. 10A and FIG. 10B is a slot after the monitoring section MP#0 in FIG. 6.

Referring to FIG. 10A, a fourth codeword located in the target slot SLOT#3 may include the 1st to 17th code blocks CB#0 to CB#16, and the fourth codeword may correspond to a fourth HARQ ID and thus have a fourth RE-CB mapping pattern. In addition, it is assumed that the fourth codeword corresponds to the primary carrier corresponding to the first to third codewords in FIG. 6.

In the fourth codeword of the target slot SLOT#3, according to the fourth RE-CB mapping pattern, the 1st code block CB#0 may be mapped to the 1st to 4th resource elements #0 to #3, the 2nd code block CB#1 may be mapped to the 5th to 8th resource elements #4 to #7, the 3rd code block CB#2 may be mapped to the 9th to 12th resource elements #8 to #11, the 4th code block CB#3 may be mapped to the 13th to 16th resource elements #12 to #15, the 5th code block CB#4 may be mapped to the 17th to 20th resource elements #16 to #19, the 6th code block CB#5 may be mapped to the 21st to 24th resource elements #20 to #23, the 7th code block CB#6 may be mapped to the 25th to 28th resource elements #24 to #27, the 8th code block CB#7 may be mapped to the 29th to 32nd resource elements #28 to #31, the 9th code block CB#8 may be mapped to the 33rd to 36th resource elements #32 to #35, the 10th code block CB#9 may be mapped to the 37th to 40th resource elements #36 to #39, the 11th code block CB#10 may be mapped to the 41st to 44th resource elements #40 to #43, the 12th code block CB#11 may be mapped to the 45th to 48th resource elements #44 to #47, the 13th code block CB#12 may be mapped to the 49th to 52nd resource elements #48 to #51, the 14th code block CB#13 may be mapped to the 53rd to 56th resource elements #52 to #55, the 15th code block CB#14 may be mapped to the 57th to 60th resource elements #56 to #59, the 16th code block CB#15 may be mapped to the 61st to 64th resource elements #60 to #63, and the 17th code block CB#16 may be mapped to the 65th to 68th resource elements #64 to #67.

Referring further to FIG. 10B, the decoding iteration control circuit 220 (FIG. 4) may generate the measurement result MRd representing the quality of the 1st to 17th code blocks CB#0 to CB#16 corresponding to the target slot on the basis of the measurement result MRc of FIG. 8B and the fourth RE-CB mapping pattern. Specifically, the quality of the 1st code block CB#0 may be defined as '12,' which is the sum of the values corresponding to the 1st to 4th resource elements #0 to #3 in the measurement result MRc (FIG. 8B), the quality of the 2nd code block CB#1 may be defined as '7,' which is the sum of the values corresponding to the 5th to 8th resource elements #4 to #7 in the measurement result MRc (FIG. 8B), the quality of the 3rd code block CB#2 may be defined as '6,' which is the sum of the values corresponding to the 9th to 12th resource elements #8 to #11 in the measurement result MRc (FIG. 8B), the quality of the 4th code block CB#3 may be defined as '7,' which is the sum of the values corresponding to the 13th to 16th resource elements #12 to #15 in the measurement result MRc (FIG. 8B), the quality of the 5th code block CB#4 may be defined as '6,' which is the sum of the values corresponding to the 17th to 20th resource elements #16 to #19 in the measurement result MRc (FIG. 8B), the quality of the 6th code block CB#5 may be defined as '12,' which is the sum of the values corresponding to the 21st to 24th resource elements #20 to #23 in the measurement result MRc (FIG. 8B), the quality of the 7th code block CB#6 may be defined as '1,' which is the sum of the values corresponding to the 25th to 28th resource elements #24 to #27 in the measurement result MRc (FIG. 8B), the quality of the 8th code block CB#7 may be defined as '4,' which is the sum of the values corresponding to the 29th to 32nd resource elements #28 to #31 in the measurement result MRc (FIG. 8B), the quality of the 9th code block CB#8 may be defined as '7,' which is the sum of the values corresponding to the 33rd to 36th resource elements #32 to #35 in the measurement result MRc (FIG. 8B), the quality of the 10th code block CB#9 may be defined as '0,' which is the sum of the values corresponding to the 37th to 40th resource elements #36 to #39 in the measurement result MRc (FIG. 8B), the quality of the 11th code block CB#10 may be defined as '8,' which is the sum of the values corresponding to the 41st to 44th resource elements #40 to #43 in the measurement result MRc (FIG. 8B), the quality of the 12th code block CB#11 may be defined as '5,' which is the sum of the values corresponding to the 45th to 48th resource elements #44 to #47 in the measurement result MRc (FIG. 8B), the quality of the 13th code block CB#12 may be defined as '10,' which is the sum of the values corresponding to the 49th to 52nd resource elements #48 to #51 in the measurement result MRc (FIG. 8B), the quality of the 14th code block CB#13 may be defined as '9,' which is the sum of the values corresponding to the 53rd to 56th resource elements #52 to #55 in the measurement result MRc (FIG. 8B), the quality of the 15th code block CB#14 may be defined as '4,' which is the sum of the values corresponding to the 57th to 60th resource elements #56 to #59 in the measurement result MRc (FIG. 8B), the quality of the 16th code block CB#15 may be defined as '12,' which is the sum of the values corresponding to the 61st to 64th resource elements #60 to #63 in the measurement result MRc (FIG. 8B), and the quality of the 17th code block CB#16 may be defined as '3,' which is the sum of the values corresponding to the 65th to 68th resource elements #64 to #67 in the measurement result MRc (FIG. 8B).

Based on the method described above, the measurement result MRd representing the quality of code blocks of the target slot may be derived from the measurement result MRc (FIG. 8B) representing the quality of resource elements.

In one or more embodiments, the decoding iteration control circuit 220 (FIG. 4) may allocate the maximum number of decoding iterations for each of the 1st to 17th code blocks CB#0 to CB#16 on the basis of the quality of the 1st to 17th code blocks CB#0 to CB#16. For example, based on the fact that the quality of the 1st code block CB#0 is '12,' which is worse than the quality of the 2nd code block CB#1, which is '7,' the decoding iteration control circuit 220 (FIG. 4) may allocate a larger maximum number of decoding iterations to the 1st code block CB#0 than to the 2nd code block CB#1.

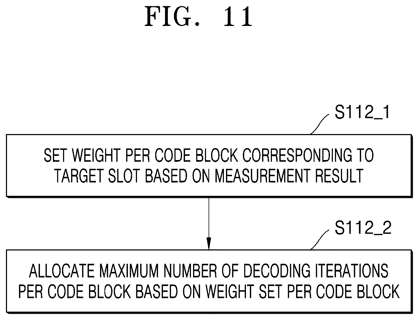

FIG. 11 is a flowchart illustrating a specific embodiment of operation S112 of FIG. 9.

Referring to FIG. 11, in operation S112_1, the decoding circuit may set a weight per code block corresponding to a target slot on the basis of the measurement results of operation S100 of FIG. 5.

In operation S112_2, the decoding circuit may allocate the maximum number of decoding iterations per code block corresponding to the target slot on the basis of the weight set per code block.

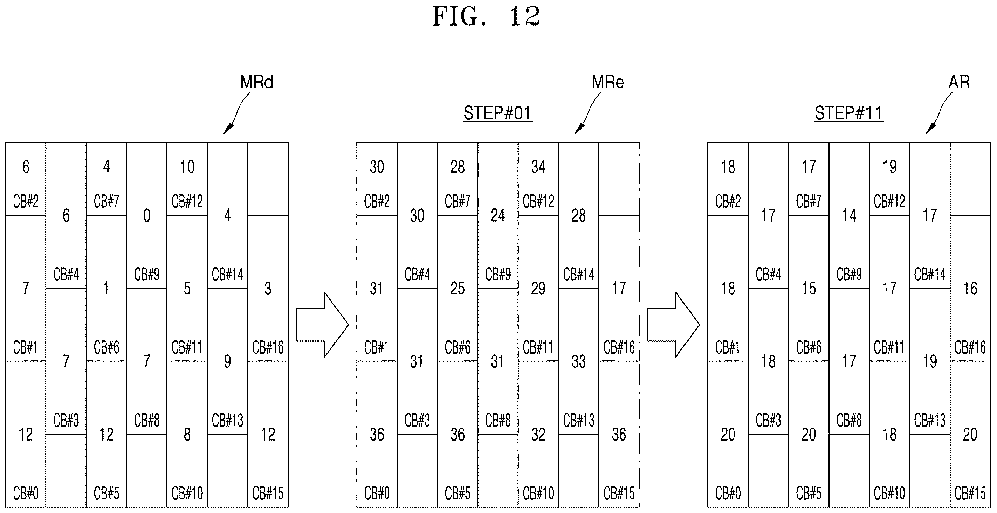

This is described below in detail with reference to FIG. 12.

FIG. 12 is a diagram illustrating a method of allocating the maximum number of decoding iterations per code block on the basis of the weight that is set per code block, according to one or more embodiments.

Referring to FIG. 12, in first operation STEP#01, the decoding iteration control circuit 220 (FIG. 4) may generate a measurement result MRe, in which the weight per code block is set, on the basis of the measurement result MRd of FIG. 10B and a certain equation. The certain equation may correspond to the following Equation 1.

$$Wp = 2 \cdot Q + Qp \qquad [Equation\ 1]$$

p may represent the index of the code block, Wp may represent the weight of the code block having the index of p, Q may represent the maximum cumulative value (e.g., '12') due to decoding failure in the measurement result MRd, and Qp may represent the value (e.g., '7' corresponding to the 2nd code block CB#1) corresponding to the code block having the index of p in the measurement result MRd. Equation 1 may represent an equation defined to perform allocation such that the ratio between the maximum number of decoding iterations of the code block (e.g., CB#9) having the best quality and the maximum number of decoding iterations of the code block (e.g., CB#0, CB#5, or CB#15) having the worst quality is 2:3 or close to 2:3. However, it should be understood that the method of setting weights according to Equation 1 is only an example and the embodiments are not limited thereto.

In the measurement result MRe, the weight corresponding to the 1st code block CB#0 may be set to '36,' the weight corresponding to the 2nd code block CB#1 may be set to '31,' the weight corresponding to the 3rd code block CB#2 may be set to '30,' the weight corresponding to the 4th code block CB#3 may be set to '31,' the weight corresponding to the 5th code block CB#4 may be set to '30,' the weight corresponding to the 6th code block CB#5 may be set to '36,' the weight corresponding to the 7th code block CB#6 may be set to '25,' the weight corresponding to the 8th code block CB#7 may be set to '28,' the weight corresponding to the 9th code block CB#8 may be set to '31,' the weight corresponding to the 10th code block CB#9 may be set to '24,' the weight corresponding to the 11th code block CB#10 may be set to '32,' the weight corresponding to the 12th code block CB#11 may be set to '29,' the weight corresponding to the 13th code block CB#12 may be set to '34,' the weight corresponding to the 14th code block CB#13 may be set to '33,' the weight corresponding to the 15th code block CB#14 may be set to '28,' the weight corresponding to the 16th code block CB#15 may be set to '36,' and the weight corresponding to the 17th code block CB#16 may be set to '17.'

In second operation STEP#11, the decoding iteration control circuit 220 (FIG. 4) may allocate the maximum number of decoding iterations per code block on the basis of the measurement result MRe and a certain equation. The certain equation may correspond to the following Equation 2.

$$Zp = Wp \cdot \frac{Z}{\sum_P Wp} \qquad \text{[Equation 2]}$$

p may represent the index of the code block, Wp may represent the weight of the code block having the index of p, Z may represent the total number of decoding iterations (e.g., '200') that may be allocated to a single codeword, and Zp may represent the maximum number of decoding iterations allocated to a code block having the index p. Also, the decoding iteration control circuit 220 (FIG. 4) may increase the maximum number of decoding iterations per code block by an increment of '1' in a certain order until all remaining iterations are consumed after the allocation based on Equation 2. For example, the decoding iteration control circuit 220 (FIG. 4) may distribute the remaining number of iterations by sequentially allocating '1' additional iteration to the code blocks that are listed in order starting from the code block assigned the smallest maximum number of decoding iterations and proceeding to the code block assigned the largest maximum number of decoding iterations. For example, the decoding iteration control circuit 220 (FIG. 4) may consume the remaining number of iterations by sequentially allocating '1' additional iteration to the code blocks that are listed from the code block having the lowest index (or the highest index) to the code block having the highest index (or the lowest index).

Based on Equation 1 and Equation 2, the decoding iteration control circuit 220 (FIG. 4) may allocate the maximum number of decoding iterations per code block, as shown in a result of allocation AR in second operation STEP#11. In other words, the 1st code block CB#0 may be allocated '20' iterations, the 2nd code block CB#1 may be allocated '18' iterations, the 3rd code block CB#2 may be allocated '18' iterations, the 4th code block CB#3 may be allocated '18' iterations, the 5th code block CB#4 may be allocated '17' iterations, the 6th code block CB#5 may be allocated '20' iterations, the 7th code block CB#6 may be allocated '15' iterations, the 8th code block CB#7 may be allocated '17' iterations, the 9th code block CB#8 may be allocated '17' iterations, the 10th code block CB#9 may be allocated '14' iterations, the 11th code block CB#10 may be allocated '18' iterations, the 12th code block CB#11 may be allocated '17' iterations, the 13th code block CB#12 may be allocated '19' iterations, the 14th code block CB#13 may be allocated '19' iterations, the 15th code block CB#14 may be allocated '17' iterations, the 16th code block CB#15 may be allocated '20' iterations, and the 17th code block CB#16 may be allocated '16' iterations.

Also, the upper limit of the maximum number of decoding iterations may be set to '20' and the lower limit of the maximum number of decoding iterations may be set to '14' by Equation 1 and Equation 2. Accordingly, the difference between the largest and smallest values in the maximum numbers of decoding iterations may be controlled not to exceed '6.' As a result, a stable and reliable decoding operation may be guaranteed.

In order to perform the stable and reliable decoding operation, the decoding iteration control circuit 220 (FIG. 4) according to one or more embodiments may correct the measurement result MRd on the basis of certain equations and then allocate the maximum number of decoding iterations per code block on the basis of the corrected measurement result MRe.

In some embodiments, the maximum number of decoding iterations per code block may be determined on the basis of the weights according to Equation 3.

$$Qp = \frac{\sum_{i \in Y} Mi}{Mp} \qquad \text{[Equation 3]}$$

p may represent the index of the code block, Qp may represent the value corresponding to the code block having the index of p, $Mp$ may represent the maximum cumulative value due to decoding failure, $Y$ may represent the total number of slots in the monitoring section, $i$ may represent the index of the slot, and $Mi$ may represent the cumulative value due to decoding failure corresponding to the pth code block in slot $i$. As the Qp increases, the quality of the pth code block deteriorates, which may represent a high probability of decoding failure. Qp may be used as a weight to be used as the basis for allocating the maximum number of decoding iterations per code block, or may be used as a flag to increase the maximum number of decoding iterations for the code block when Qp is greater than a certain threshold.

However, this is only an example, and the embodiments may be implemented in other embodiments.

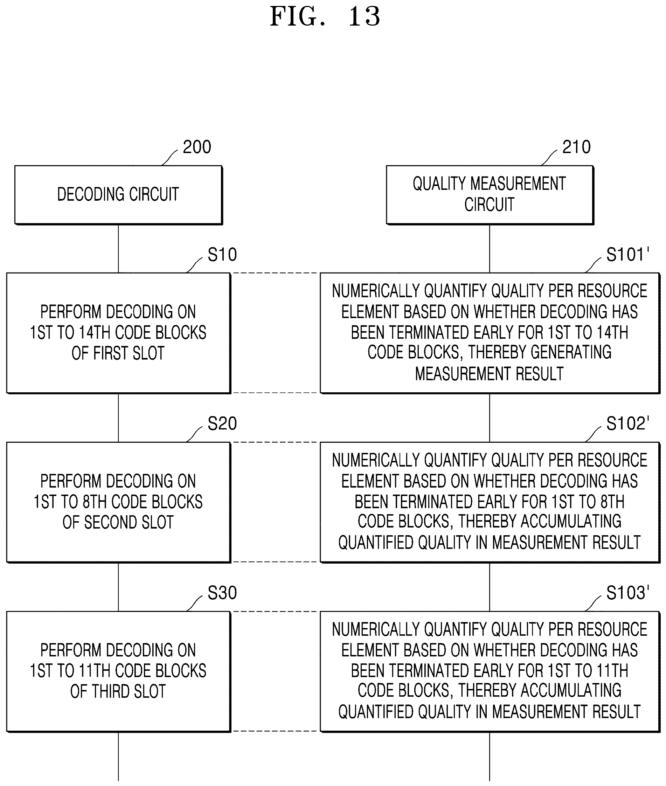

FIG. 13 is a flowchart illustrating a method of operating the decoding circuit 200 and the quality measurement circuit 210 in the monitoring section MP#0 of FIG. 6. FIG. 13 shows a specific embodiment of operation S100 of FIG. 5.

Referring to FIG. 13, in operation S10, the decoding circuit 200 may decode the 1st to 14th code blocks CB#0 to CB#13 in the first slot SLOT#0. For example, the decoding circuit 200 may sequentially perform decoding operations for error correction per code block on the 1st to 14th code blocks CB#0 to CB#13.

In operation S101', the quality measurement circuit 210 may generate the measurement results by numerically quantifying the quality per resource element on the basis of whether or not the decoding has been terminated early for the 1st to 14th code blocks CB#0 to CB#13 that have been identified in operation S10. In a specific example, the quality measurement circuit 210 may identify resource elements that are mapped to a code block for which decoding has been terminated early among the 1st to 14th code blocks CB#0 to CB#13 on the basis of the first RE-CB mapping pattern, and may generate the measurement results by using the numerically quantified value according to the early termination of decoding for each of the identified resource elements.

In operation S20, the decoding circuit 200 may decode the 1st to 8th code blocks CB#0 to CB#7 of the second slot SLOT#1. For example, the decoding circuit 200 may sequentially perform decoding operations for error correction per code block on the 1st to 8th code blocks CB#0 to CB#7.

In operation S102', the quality measurement circuit 210 may numerically quantify the quality per resource element on the basis of whether or not the decoding has been terminated early for the 1st to 8th code blocks CB#0 to CB#7 that have been identified in operation S20, and may accumulate the numerically quantified quality in the measurement results. In a specific example, the quality measurement circuit 210 may identify resource elements that are mapped to a code block for which decoding has been terminated early among the 1st to 8th code blocks CB#0 to CB#7 on the basis of the second RE-CB mapping pattern, and may accumulate (or update) the measurement results by using the numerically quantified value according to the early termination of decoding for each of the identified resource elements.

In operation S30, the decoding circuit 200 may decode the 1st to 11th code blocks CB#0 to CB#10 of the third slot SLOT#2. For example, the decoding circuit 200 may sequentially perform decoding operations for error correction per code block on the 1st to 11th code blocks CB#0 to CB#10.

In operation S103', the quality measurement circuit 210 may numerically quantify the quality per resource element on the basis of whether or not the decoding has been terminated early for the 1st to 11th code blocks CB#0 to CB#10 that have been identified in operation S30, and may accumulate the numerically quantified quality in the measurement results. In a specific example, the quality measurement circuit 210 may identify resource elements that are mapped to a code block for which decoding has been terminated early among the 1st to 11th code blocks CB#0 to CB#10 on the basis of the third RE-CB mapping pattern, and may accumulate (or update) the measurement results by using the numerically quantified value according to the early termination of decoding for each of the identified resource elements.

In some embodiments, the quality measurement circuit 210 may measure the quality of resource elements by considering whether decoding for a code block has terminated early and failed or by applying weights thereto.

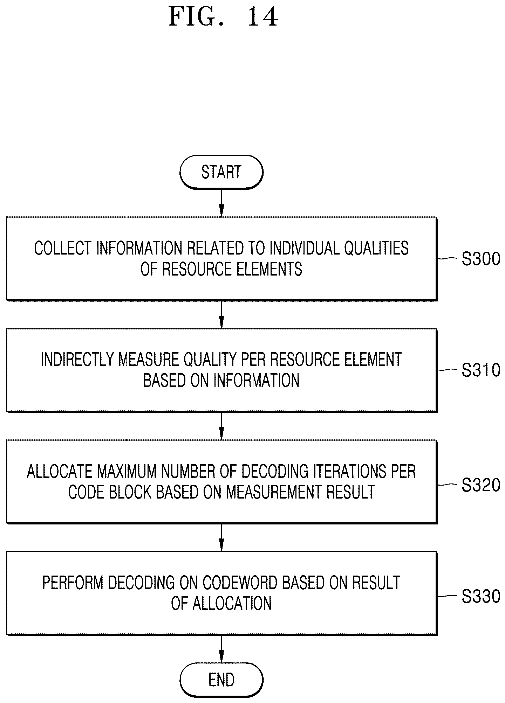

FIG. 14 is a flowchart illustrating a method of operating the decoding circuit according to one or more embodiments. Also, the operation of the decoding circuit in FIG. 14 may be understood as the operation of a baseband processor, a modem chip, or an electronic device that includes the decoding circuit.

Referring to FIG. 14, in operation S300, the decoding circuit may collect information related to individual qualities of resource elements. For example, the decoding circuit may collect at least one of the first information about the center frequency, the second information about the slot that changes from uplink to downlink, the third information about the resource element located at the edge on the basis of the frequency axis, and the fourth information about the arrangement of the DMRS.

In operation S310, the decoding circuit may indirectly measure the quality per resource element on the basis of the information collected in operation S300. For example, the decoding circuit may predict, based on the first information, that the quality of resource elements in a certain range around the center frequency is poor. Based on the second information, the decoding circuit may identify that the target slot corresponds to a transition between uplink and downlink and may predict that the quality of the resource elements located at the front end of the target slot is poor. The decoding circuit may predict, based on the third information, that the quality of resource elements located at the frequency edge is poor. Also, the decoding circuit may predict, based on the fourth information, that resource elements, which are located farther than the critical distance from the resource elements on which the DMRS is located, have poor quality.

In operation S320, the decoding circuit may allocate the maximum number of decoding iterations per code block on the basis of the measurement results in operation S310. For example, based on the RE-CB mapping pattern corresponding to the target slot, the decoding circuit may identify the code blocks to which resource elements that were measured to have poor quality have been mapped. The decoding circuit may allocate a smaller maximum number of decoding iterations to the identified code blocks than to the remaining code blocks.

In operation S330, the decoding circuit may decode the codeword located in the target slot on the basis of the results of allocation in operation S320. For example, the decoding circuit may decode per code block on the basis of the maximum number of decoding iterations allocated for each of the plurality of code blocks of the codeword located in the target slot.

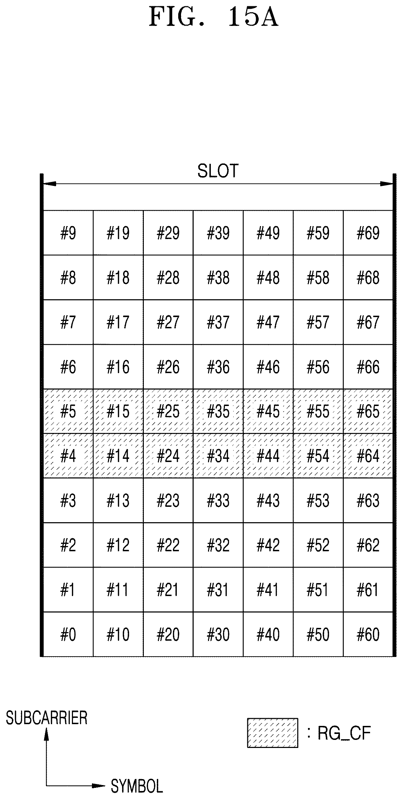

FIGS. 15A to 15D illustrate a method of indirectly measuring the quality of resource elements #0 to #69, according to one or more embodiments.

Referring to FIG. 15A, the resource elements #4, #5, #14, #15, #24, #25, #34, #35, #44, #45, #54, #55, #64, and #65, which are in a predetermined range RG_CF adjacent to the center frequency of a component carrier corresponding to the codeword located in the slot SLOT may have poor quality. Accordingly, the code blocks to which the resource elements #4, #5, #14, #15, #24, #25, #34, #35, #44, #45, #54, #55, #64, and #65 are mapped may be allocated a larger maximum number of decoding iterations than other code blocks. In addition, a larger maximum number of decoding iterations may be allocated to a code block to which many resource elements among the corresponding resource elements #4, #5, #14, #15, #24, #25, #34, #35, #44, #45, #54, #55, #64, and #65 are mapped than to a code block to which fewer resource elements among the corresponding resource elements #4, #5, #14, #15, #24, #25, #34, #35, #44, #45, #54, #55, #64, and #65 are mapped.

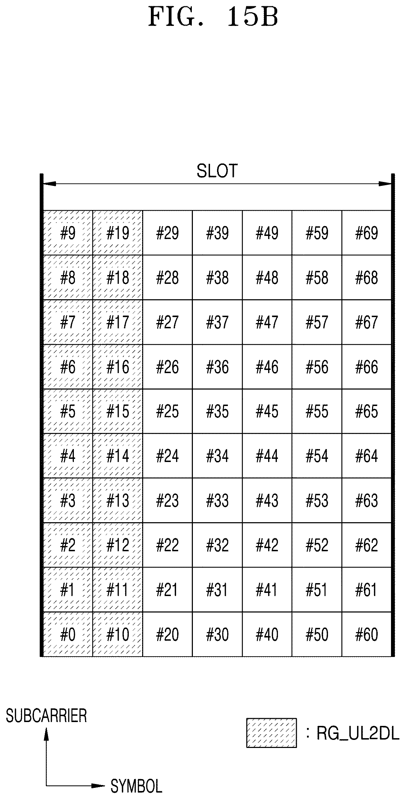

Referring to FIG. 15B, when a slot SLOT corresponds to a slot that changes from uplink to downlink, the resource elements #0 to #19 in a predetermined range RG_UL2DL located at the front of the slot SLOT may have poor quality. Accordingly, a larger maximum number of decoding iterations may be allocated to the code blocks to which the corresponding resource elements #0 to #19 are mapped than to other code blocks. In addition, a larger maximum number of decoding iterations may be allocated to a code block to which many resource elements among the resource elements #0 to #19 are mapped than to a code block to which fewer resource elements among the resource elements #0 to #19 are mapped.

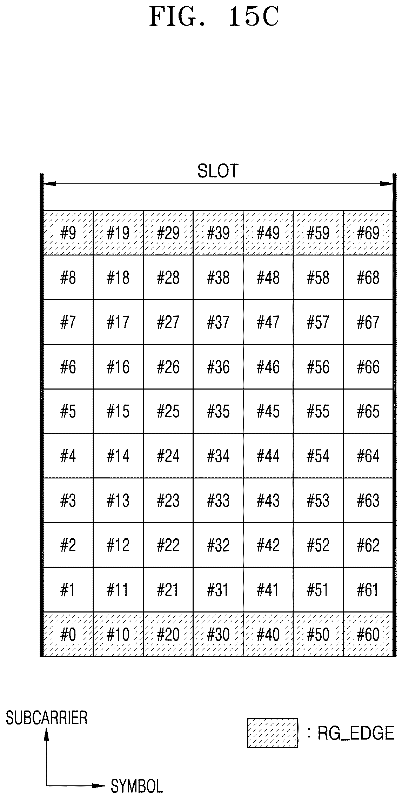

Referring further to FIG. 15C, the resource elements #0, #10, #20, #30, #40, #50, #60, #9, #19, #29, #39, #49, #59, and #69, which are in a predetermined range RG_EDGE located at the edge of the slot SLOT on the basis of the frequency axis, may have poor quality. Accordingly, the code blocks to which the resource elements #0, #10, #20, #30, #40, #50, #60, #9, #19, #29, #39, #49, #59, and #69 are mapped may be allocated a larger maximum number of decoding iterations than other code blocks. In addition, a larger maximum number of decoding iterations may be allocated to a code block to which many resource elements are among the corresponding resource elements #0, #10, #20, #30, #40, #50, #60, #9, #19, #29, #39, #49, #59, and #69 mapped than to a code block to which fewer resource elements among the corresponding resource elements #0, #10, #20, #30, #40, #50, #60, #9, #19, #29, #39, #49, #59, and #69 are mapped.

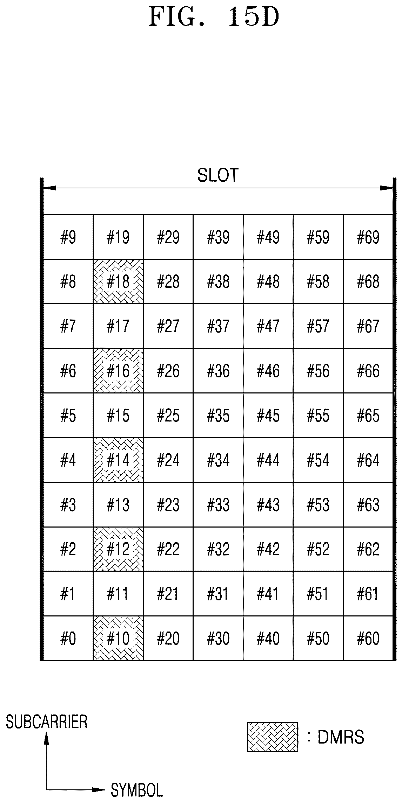

Referring further to FIG. 15D, the DMRS may be located in some resource elements #10, #12, #14, #16, and #18 in the slot SLOT, and the resource elements located farther than a critical distance from some resource elements #10, #12, #14, #16, and #18 may have poor quality. Accordingly, a larger maximum number of decoding iterations may be allocated to the code blocks to which the corresponding resource elements are mapped than to other code blocks. In addition, a larger maximum number of decoding iterations may be allocated to a code block to which many resource elements among the resource elements are mapped than to a code block to which fewer resource elements among the resource elements are mapped.

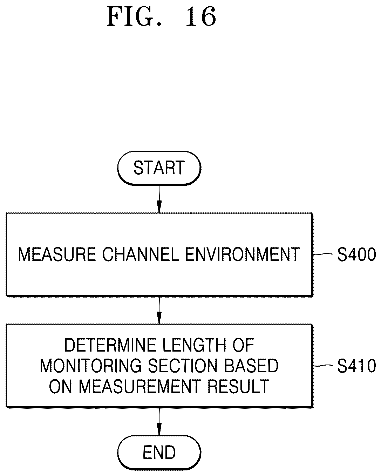

FIG. 16 is a flowchart illustrating a method of operating the decoding circuit according to one or more embodiments. Also, the operation of the decoding circuit in FIG. 16 may be understood as the operation of a baseband processor, a modem chip, or an electronic device that includes the decoding circuit.

Referring to FIG. 16, in operation S400, the decoding circuit may measure a channel environment.

In operation S410, the decoding circuit may determine the length of the monitoring section on the basis of the measurement results of operation S400. For example, the decoding circuit may determine to lengthen the monitoring section when the channel environment is measured to be changing rapidly, and to shorten the monitoring section when the channel environment is measured to be relatively stable or changing slowly. However, this is only an example, and the embodiment is not limited thereto. The decoding circuit may determine the length of the monitoring section on the basis of other methods.

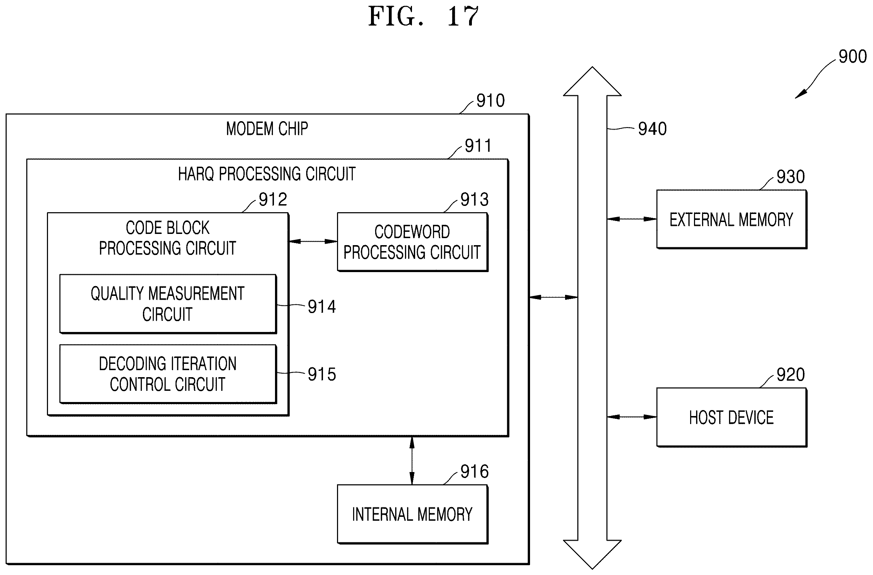

FIG. 17 is a block diagram schematically showing a system-on-chip 900 according to one or more embodiments.

Referring to FIG. 17, the system-on-chip 900 may include a modem chip 910, a host device 920, external memory 930, and a bus interface 940.

In one or more embodiments, the external memory 930 may include memory accessible to the modem chip 910 and the host device 920 via the bus interface 940, and may be shared by the modem chip 910 and the host device 920. As used herein, the external memory 930 and internal memory 916 are defined relative to the modem chip 910. The external memory 930 may be memory physically separated from the modem chip 910, and the internal memory 916 may be memory located inside the modem chip 910.

In one or more embodiments, the host device 920 may access the external memory 930 via the bus interface 940. For example, the host device 920 may include a central processing unit (CPU), a graphics processing unit (GPU), a neural processing unit (NPU), or other types of devices for processing data.

In one or more embodiments, the modem chip 910 may include an HARQ processing circuit 911 and the internal memory 916. In various mobile communication standards, such as LTE and NR, the HARQ function is defined, and the HARQ processing circuit 911 may support the HARQ function according to the mobile communication standards. The HARQ processing circuit 911 may be implemented as hardware for performing the embodiments described above, or may be implemented as software executed by a processor within the modem chip 910. In some embodiments, the HARQ processing circuit 911 may be implemented as a combination of software and hardware. For example, the internal memory 916 may be implemented as volatile memory dedicated to the modem chip 910.

In one or more embodiments, the HARQ processing circuit 911 may include a code block processing circuit 912 and a codeword processing circuit 913. The code block processing circuit 912 may perform processing operation on a received codeword in units of code blocks, and the codeword processing circuit 913 may perform processing operation in units of codewords on the basis of the results of processing in units of code blocks performed by the code block processing circuit 912.

In one or more embodiments, the code block processing circuit 912 may include a quality measurement circuit 914 and a decoding iteration control circuit 915. As described above, the quality measurement circuit 914 may measure the quality of the plurality of resource elements on the basis of the RE-CB mapping pattern. In addition, the decoding iteration control circuit 915 may allocate the maximum number of decoding iterations per code block on the basis of the RE-CB mapping pattern and the quality of the plurality of resource elements as described above.

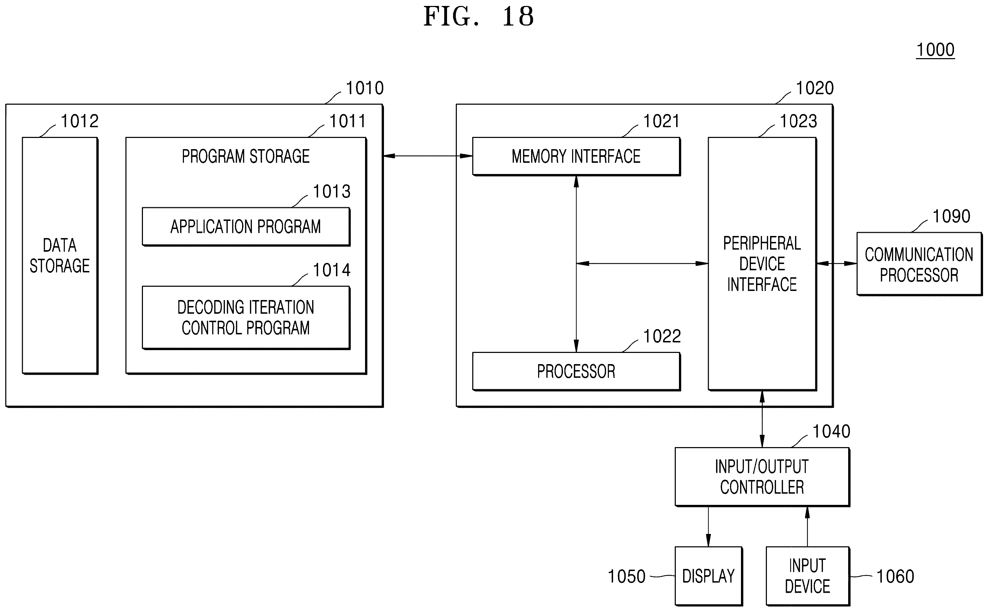

FIG. 18 is a block diagram showing an electronic device 1000 according to one or more embodiments.

Referring to FIG. 18, the electronic device 1000 may include memory 1010, a processor 1020, an input/output controller 1040, a display 1050, an input device 1060, and a communication processor 1090. Here, the memory 1010 may be provided in plurality, i.e., the electronic device 1000 may comprise multiple memories 1010. Each of the components is described below.

The memory 1010 may include a program storage 1011 for storing a program that controls an operation of the electronic device 1000 and a data storage 1012 for storing data that is generated during execution of the program. The data storage 1012 may store data required for operations of an application program 1013 and a decoding iteration control program 1014.

The program storage 1011 may include the application program 1013 and the decoding iteration control program 1014. Here, the program in the program storage 1011 may be expressed as an instruction set, which is a group of instructions. The application program 1013 may include pieces of program code for performing various applications running on the electronic device 1000. In other words, the application program 1013 may include pieces of codes (or commands) for various applications that are driven by a processor 1022. The decoding iteration control program 1014 may include pieces of control codes for measuring the quality of resource elements according to embodiments and allocating the maximum number of decoding iterations per code block on the basis of the measurement results.

In one or more embodiments, the processor 1022 may measure the quality of resource elements by executing the decoding iteration control program 1014 and may allocate the maximum number of decoding iterations per code block on the basis of the measurement results. In addition, the RE-CB mapping pattern may be referenced in the operation described above.

Also, the electronic device 1000 may include the communication processor 1090 that performs communication functions for voice communication and data communication. A peripheral device interface 1023 may control connections between the input/output controller 1040, the communication processor 1090, the processor 1022, and a memory interface 1021.

The input/output controller 1040 may provide an interface between an input/output device, such as the display 1050 and the input device 1060, and the peripheral device interface 1023. The display 1050 displays state information, texts being input, moving pictures, and still pictures. For example, the display 1050 may display information on the application program driven by the processor 1022.

The input device 1060 may provide input data generated by the selection of the electronic device 1000 to the processor 1020 via the input/output controller 1040. Here, the input device 1060 may include a keypad including at least one hardware button and a touch pad for sensing touch information. For example, the input device 1060 may provide the processor 1022 with touch information, such as touch, touch movement, and touch release, sensed by the touch pad, via the input/output controller 1040.

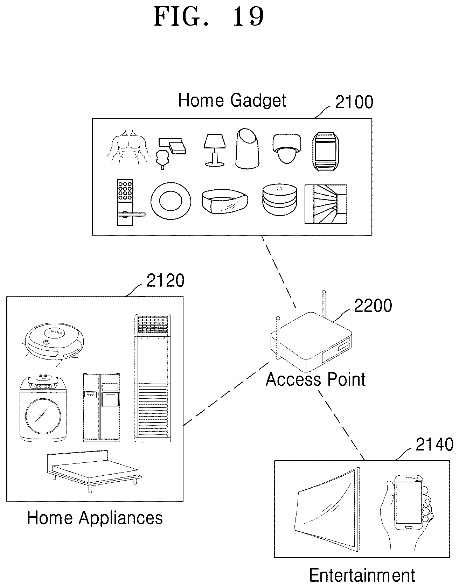

FIG. 19 is a diagram showing communication devices configured to perform a decoding operation according to one or more embodiments.

Referring to FIG. 19, modem chips, which are included in home gadget 2100, home appliances 2120, entertainment devices 2140, and access points (APs) 2200, may perform decoding operations in units of code blocks after allocating the maximum number of decoding iterations per code block according to the embodiments.

In some embodiments, the home gadget 2100, the home appliances 2120, the entertainment devices 2140, and the APs 2200 may form an internet of things (IoT) network system. The communication devices illustrated in FIG. 19 are only examples, and it will be understood that other communication devices not illustrated in FIG. 19 may also include a wireless communication device according to the embodiment.

While the inventive concept has been particularly shown and described with reference to embodiments thereof, it will be understood that various changes in form and details may be made therein without departing from the scope of the following claims.

**Claims**

1. A method of operating a modem chip (910), the method comprising:

   measuring (S100) quality of a plurality of resource elements (212) allocated to receive a codeword;
   allocating (S110) a maximum number of decoding iterations per code block based on a measurement result of the quality and a resource element-to-code block, RE-CB, mapping pattern corresponding to a target slot; and
   decoding a plurality of first code blocks of the target slot based on the allocated maximum number of decoding iterations per code block.

2. The method of claim 1, wherein the measuring (S100) of the quality of the plurality of resource elements comprises: measuring the quality of the plurality of resource elements based on a result of decoding a plurality of code blocks corresponding to a monitoring section that precedes the target slot.

3. The method of claim 2, wherein the result of the decoding comprises either one or both of a result on whether the decoding has failed for the plurality of code blocks corresponding to the monitoring section and a result on whether the decoding for the plurality of code blocks corresponding to the monitoring section has completed prior to reaching the maximum number of decoding iterations.

4. The method of claim 2 or 3, wherein the monitoring section comprises a plurality of slots.

5. The method of any of claims 2 to 4, wherein a length of the monitoring section varies depending on a channel environment.

6. The method of claim 2, wherein the monitoring section comprises a first slot and a second slot, and wherein the measuring of the quality of the plurality of resource elements comprises:

   generating a first measurement result by numerically quantifying the quality per resource element based on whether decoding has failed for a plurality of second code blocks in the first slot and an RE-CB mapping pattern corresponding to the first slot; and
   generating a second measurement result by numerically quantifying the quality per resource element based on whether decoding has failed for a plurality of third code blocks in the second slot and an RE-CB mapping pattern corresponding to the second slot, and accumulating the quantified quality for the second slot in the first measurement result.

7. The method of claim 2, wherein the monitoring section comprises a first slot and a second slot, and wherein the measuring of the quality of the plurality of resource elements comprises:

   generating a first measurement result by numerically quantifying the quality per resource element based on whether decoding for a plurality of second code blocks in the first slot has completed prior to reaching the maximum number of decoding iterations and an RE-CB mapping pattern corresponding to the first slot; and
   generating a second measurement result by numerically quantifying the quality per resource element based on whether decoding for a plurality of third code blocks in the second slot has completed prior to reaching the maximum number of decoding iterations and an RE-CB mapping pattern corresponding to the second slot.

8. The method of claim 1, wherein the measuring (S100) of the quality of the plurality of resource elements comprises:

   collecting (S300) information related to the quality of the plurality of resource elements; and
   measuring the quality of the plurality of resource elements based on the information.

9. The method of claim 8, wherein the information related to the quality comprises at least one of: first information indicating a center frequency, second information indicating a slot transition between uplink and downlink, third information indicating a resource element located at an edge along a frequency axis, and fourth information indicating an arrangement of a demodulation reference signal, DMRS.

10. The method of any preceding claim, wherein the allocating (S110) of the maximum number of decoding iterations per code block comprises:

identifying, based on the RE-CB mapping pattern corresponding to the target slot, resource elements corresponding to a first code block among the plurality of resource elements; and

allocating, based on the quality of the resource elements identified in the measurement result, the maximum number of decoding iterations for the first code block.

11. The method of any preceding claim, wherein the allocating (S110) of the maximum number of decoding iterations per code block comprises:

setting (S112_1), based on the measurement result, a weight per code block corresponding to the target slot; and

allocating (S112_2), based on a result of the setting the weight per code block, the maximum number of decoding iterations per code block.

12. The method of claim 11, wherein the maximum number of decoding iterations per code block is within a range bounded by a predetermined upper limit or a predetermined lower limit.

13. The method of any preceding claim, wherein the RE-CB mapping pattern corresponding to the target slot conforms to a hybrid automatic repeat request, HARQ, identifier corresponding to a first codeword comprising the plurality of first code blocks.

14. The method of any preceding claim, wherein the performing of decoding on the plurality of first code blocks comprises: repeatedly attempting to decode a first code block included in the plurality of first code blocks, until the first code block is successfully decoded or until the maximum number of decoding iterations corresponding to the first code block, is reached.

15. A modem chip (910) comprising:

memory; and
a processing circuit configured to access the memory to:

allocate a maximum number of decoding iterations per code block based on quality of a plurality of resource elements allocated to receive a codeword and a resource element-to-code block, RE-CB, mapping pattern corresponding to a target slot; and

decode a plurality of first code blocks of the target slot based on the allocated maximum number of decoding iterations per code block.

# FIG. 1

ELECTRONIC DEVICE _100

BASEBAND PROCESSOR _110

DECODING CIRCUIT (BASED ON RE-CB MAPPING PATTERN) _112

TRANSCEIVER _120

INTERFACE CIRCUIT _130

MEMORY _140

150_1
150_2
150_k

# FIG. 2A

214

RADIO FRAME

SUBFRAME — 205

· · ·

SLOT — 206

212

RESOURCE ELEMENT

$N_{BW}$ SUBCARRIERS

$N_{RB}$ SUBCARRIERS

204

209

RESOURCE BLOCK

208

$N_{symb}$ OFDM SYMBOLS

202

FREQUENCY

TIME

FIG. 2B

1 RADIO FRAME — 300

1 SUBFRAME — 301

304

305

μ = 0: 0 | 1 | 2 | 3 | 4 | 5 | 6 | 7 | 8 | 9

SLOT — 302

μ = 1: 0 | 1 | 2 | 3 | 4 | 5 | 6 | 7 | 8 | 9 | 10 | 11 | 12 | 13 | 14 | 15 | 16 | 17 | 18 | 19

SLOT — 303

EP 4 765 699 A1

# FIG. 2C

| SLOT | | | | | | |
|------|------|------|------|------|------|------|
| #9 | #19 | #29 | #39 | #49 | #59 | #69 |
| #8 | #18 | #28 | #38 | #48 | #58 | #68 |
| #7 | #17 | #27 | #37 | #47 | #57 | #67 |
| #6 | #16 | #26 | #36 | #46 | #56 | #66 |
| #5 | #15 | #25 | #35 | #45 | #55 | #65 |
| #4 | #14 | #24 | #34 | #44 | #54 | #64 |
| #3 | #13 | #23 | #33 | #43 | #53 | #63 |
| #2 | #12 | #22 | #32 | #42 | #52 | #62 |
| #1 | #11 | #21 | #31 | #41 | #51 | #61 |
| #0 | #10 | #20 | #30 | #40 | #50 | #60 |

SUBCARRIER

SYMBOL

# FIG. 3

CW

TB

CB#0  CB#1  CB#2  CB#3  ...  CB#(m-2)  CB#(m-1)

▨ :TBCRC BITS

▨ :CRC BITS

# FIG. 4

DECODING CIRCUIT — 200

QUALITY MEASUREMENT CIRCUIT
(BY RESOURCE ELEMENT UNIT) — 210

DECODING ITERATION
CONTROL CIRCUIT
(BY CODE BLOCK UNIT) — 220

RE-CB MAPPING TABLE — 230

# FIG. 5

```
      ┌─────────┐
      │  START  │
      └─────────┘
           │
           ▼
┌──────────────────────────────┐
│   MEASURE QUALITY PER RESOURCE│
│ ELEMENT BASED ON RESULT OF    │── S100
│ DECODING CODE BLOCKS IN       │
│ MONITORING SECTION            │
└──────────────────────────────┘
           │
           ▼
┌──────────────────────────────┐
│   ALLOCATE MAXIMUM NUMBER OF  │
│ DECODING ITERATIONS PER CODE  │── S110
│ BLOCK BASED ON MEASUREMENT    │
│ RESULT                        │
└──────────────────────────────┘
           │
           ▼
┌──────────────────────────────┐
│  PERFORM DECODING ON CODEWORD │── S120
│   BASED ON RESULT OF ALLOCATION│
└──────────────────────────────┘
           │
           ▼
      ┌─────────┐
      │   END   │
      └─────────┘
```

FIG. 6

# FIG. 7

**200 — DECODING CIRCUIT**

**210 — QUALITY MEASUREMENT CIRCUIT**

**S10** — PERFORM DECODING ON 1ST TO 14TH CODE BLOCKS OF FIRST SLOT

**S101** — NUMERICALLY QUANTIFY QUALITY PER RESOURCE ELEMENT BASED ON WHETHER DECODING HAS FAILED FOR 1ST TO 14TH CODE BLOCKS, THEREBY GENERATING MEASUREMENT RESULT

**S20** — PERFORM DECODING ON 1ST TO 8TH CODE BLOCKS OF SECOND SLOT

**S102** — NUMERICALLY QUANTIFY QUALITY PER RESOURCE ELEMENT BASED ON WHETHER DECODING HAS FAILED FOR 1ST TO 8TH CODE BLOCKS, THEREBY ACCUMULATING QUANTIFIED QUALITY IN MEASUREMENT RESULT

**S30** — PERFORM DECODING ON 1ST TO 11TH CODE BLOCKS OF THIRD SLOT

**S103** — NUMERICALLY QUANTIFY QUALITY PER RESOURCE ELEMENT BASED ON WHETHER DECODING HAS FAILED FOR 1ST TO 11TH CODE BLOCKS, THEREBY ACCUMULATING QUANTIFIED QUALITY IN MEASUREMENT RESULT

# FIG. 8A

| | : DECODING SUCCESS |
| --- | --- |
| | : DECODING FAILURE |

## FIG. 8B

STEP#00　　　　　　　MRa

| 0 | 0 | 0 | 0 | 0 | 0 | 0 |
|---|---|---|---|---|---|---|
| 0 | 0 | 0 | 0 | 0 | 0 | 0 |
| 0 | 0 | 0 | 0 | 0 | 0 | 0 |
| 0 | 0 | 0 | 0 | 0 | 0 | 0 |
| 0 | 0 | 0 | 0 | 0 | 0 | 0 |
| 1 | 1 | 1 | 1 | 1 | 1 | 1 |
| 1 | 1 | 1 | 1 | 1 | 1 | 1 |
| 1 | 1 | 1 | 1 | 1 | 1 | 1 |
| 1 | 1 | 1 | 1 | 1 | 1 | 1 |
| 1 | 1 | 1 | 1 | 1 | 1 | 1 |

STEP#10　　　　　　　MRb

| 1 | 1 | 0 | 0 | 1 | 1 | 0 |
|---|---|---|---|---|---|---|
| 1 | 1 | 0 | 0 | 1 | 1 | 0 |
| 1 | 1 | 0 | 0 | 1 | 1 | 0 |
| 1 | 1 | 0 | 0 | 1 | 1 | 0 |
| 1 | 1 | 0 | 0 | 1 | 1 | 0 |
| 2 | 2 | 1 | 1 | 2 | 2 | 1 |
| 2 | 2 | 2 | 1 | 2 | 2 | 2 |
| 2 | 2 | 2 | 1 | 2 | 2 | 2 |
| 2 | 2 | 2 | 1 | 2 | 2 | 2 |
| 2 | 2 | 2 | 1 | 2 | 2 | 2 |

STEP#20　　　　　　　MRc

| 1 | 2 | 0 | 0 | 2 | 1 | 0 |
|---|---|---|---|---|---|---|
| 1 | 2 | 0 | 0 | 2 | 1 | 0 |
| 1 | 1 | 0 | 0 | 1 | 1 | 0 |
| 1 | 1 | 0 | 0 | 1 | 1 | 0 |
| 2 | 1 | 0 | 1 | 1 | 1 | 1 |
| 3 | 2 | 1 | 2 | 2 | 2 | 2 |
| 3 | 2 | 3 | 2 | 2 | 3 | 3 |
| 3 | 2 | 3 | 2 | 2 | 3 | 3 |
| 3 | 2 | 3 | 2 | 2 | 3 | 3 |
| 3 | 2 | 3 | 2 | 2 | 3 | 3 |

EP 4 765 699 A1

# FIG. 9

S111

IDENTIFY RE-CB MAPPING PATTERN
CORRESPONDING TO TARGET SLOT

S112

ALLOCATE MAXIMUM NUMBER OF DECODING ITERATIONS
PER CODE BLOCK CORRESPONDING TO TARGET SLOT
BASED ON MEASUREMENT RESULT

# FIG. 10A

FIG. 10B

# FIG. 11

S112_1

SET WEIGHT PER CODE BLOCK CORRESPONDING TO
TARGET SLOT BASED ON MEASUREMENT RESULT

S112_2

ALLOCATE MAXIMUM NUMBER OF DECODING ITERATIONS
PER CODE BLOCK BASED ON WEIGHT SET PER CODE BLOCK

FIG. 12

EP 4 765 699 A1

MRd

STEP#01    MRe

STEP#11    AR

| 6 CB#2 | 6 | 4 CB#7 | 0 | 10 CB#12 | 4 | |
| 7 CB#1 | 7 | 1 CB#6 | 7 | 5 CB#11 | 9 | 3 CB#16 |
| 12 CB#0 | | 12 CB#5 | | 8 CB#10 | | 12 CB#15 |

| 30 CB#2 | 30 | 28 CB#7 | 24 | 34 CB#12 | 28 | |
| 31 CB#1 | 31 | 25 CB#6 | 31 | 29 CB#11 | 33 | 17 CB#16 |
| 36 CB#0 | | 36 CB#5 | | 32 CB#10 | | 36 CB#15 |

| 18 CB#2 | 17 | 17 CB#7 | 14 | 19 CB#12 | 17 | |
| 18 CB#1 | 18 | 15 CB#6 | 17 | 17 CB#11 | 19 | 16 CB#16 |
| 20 CB#0 | | 20 CB#5 | | 18 CB#10 | | 20 CB#15 |

# FIG. 13

**200**

DECODING CIRCUIT

**210**

QUALITY MEASUREMENT CIRCUIT

**S10**

PERFORM DECODING ON 1ST TO 14TH CODE BLOCKS OF FIRST SLOT

**S101'**

NUMERICALLY QUANTIFY QUALITY PER RESOURCE ELEMENT BASED ON WHETHER DECODING HAS BEEN TERMINATED EARLY FOR 1ST TO 14TH CODE BLOCKS, THEREBY GENERATING MEASUREMENT RESULT

**S20**

PERFORM DECODING ON 1ST TO 8TH CODE BLOCKS OF SECOND SLOT

**S102'**

NUMERICALLY QUANTIFY QUALITY PER RESOURCE ELEMENT BASED ON WHETHER DECODING HAS BEEN TERMINATED EARLY FOR 1ST TO 8TH CODE BLOCKS, THEREBY ACCUMULATING QUANTIFIED QUALITY IN MEASUREMENT RESULT

**S30**

PERFORM DECODING ON 1ST TO 11TH CODE BLOCKS OF THIRD SLOT

**S103'**

NUMERICALLY QUANTIFY QUALITY PER RESOURCE ELEMENT BASED ON WHETHER DECODING HAS BEEN TERMINATED EARLY FOR 1ST TO 11TH CODE BLOCKS, THEREBY ACCUMULATING QUANTIFIED QUALITY IN MEASUREMENT RESULT

# FIG. 14

```
                        ( START )
                            │
                            ▼
┌──────────────────────────────────────────────────┐
│  COLLECT INFORMATION RELATED TO INDIVIDUAL         │──── S300
│  QUALITIES OF RESOURCE ELEMENTS                    │
└──────────────────────────────────────────────────┘
                            │
                            ▼
┌──────────────────────────────────────────────────┐
│  INDIRECTLY MEASURE QUALITY PER RESOURCE ELEMENT   │──── S310
│  BASED ON INFORMATION                              │
└──────────────────────────────────────────────────┘
                            │
                            ▼
┌──────────────────────────────────────────────────┐
│  ALLOCATE MAXIMUM NUMBER OF DECODING ITERATIONS    │──── S320
│  PER CODE BLOCK BASED ON MEASUREMENT RESULT        │
└──────────────────────────────────────────────────┘
                            │
                            ▼
┌──────────────────────────────────────────────────┐
│  PERFORM DECODING ON CODEWORD BASED ON RESULT      │──── S330
│  OF ALLOCATION                                     │
└──────────────────────────────────────────────────┘
                            │
                            ▼
                        ( END )
```

# FIG. 15A

| SLOT | | | | | | |
|---|---|---|---|---|---|---|
| #9 | #19 | #29 | #39 | #49 | #59 | #69 |
| #8 | #18 | #28 | #38 | #48 | #58 | #68 |
| #7 | #17 | #27 | #37 | #47 | #57 | #67 |
| #6 | #16 | #26 | #36 | #46 | #56 | #66 |
| #5 | #15 | #25 | #35 | #45 | #55 | #65 |
| #4 | #14 | #24 | #34 | #44 | #54 | #64 |
| #3 | #13 | #23 | #33 | #43 | #53 | #63 |
| #2 | #12 | #22 | #32 | #42 | #52 | #62 |
| #1 | #11 | #21 | #31 | #41 | #51 | #61 |
| #0 | #10 | #20 | #30 | #40 | #50 | #60 |

SUBCARRIER

SYMBOL

▨ : RG_CF

# FIG. 15B

SLOT

| | | | | | | |
|---|---|---|---|---|---|---|
| #9 | #19 | #29 | #39 | #49 | #59 | #69 |
| #8 | #18 | #28 | #38 | #48 | #58 | #68 |
| #7 | #17 | #27 | #37 | #47 | #57 | #67 |
| #6 | #16 | #26 | #36 | #46 | #56 | #66 |
| #5 | #15 | #25 | #35 | #45 | #55 | #65 |
| #4 | #14 | #24 | #34 | #44 | #54 | #64 |
| #3 | #13 | #23 | #33 | #43 | #53 | #63 |
| #2 | #12 | #22 | #32 | #42 | #52 | #62 |
| #1 | #11 | #21 | #31 | #41 | #51 | #61 |
| #0 | #10 | #20 | #30 | #40 | #50 | #60 |

SUBCARRIER

SYMBOL

: RG_UL2DL

FIG. 15C

SLOT

| #9 | #19 | #29 | #39 | #49 | #59 | #69 |
| #8 | #18 | #28 | #38 | #48 | #58 | #68 |
| #7 | #17 | #27 | #37 | #47 | #57 | #67 |
| #6 | #16 | #26 | #36 | #46 | #56 | #66 |
| #5 | #15 | #25 | #35 | #45 | #55 | #65 |
| #4 | #14 | #24 | #34 | #44 | #54 | #64 |
| #3 | #13 | #23 | #33 | #43 | #53 | #63 |
| #2 | #12 | #22 | #32 | #42 | #52 | #62 |
| #1 | #11 | #21 | #31 | #41 | #51 | #61 |
| #0 | #10 | #20 | #30 | #40 | #50 | #60 |

SUBCARRIER

SYMBOL

: RG_EDGE

# FIG. 15D

SLOT

| #9 | #19 | #29 | #39 | #49 | #59 | #69 |
| #8 | #18 | #28 | #38 | #48 | #58 | #68 |
| #7 | #17 | #27 | #37 | #47 | #57 | #67 |
| #6 | #16 | #26 | #36 | #46 | #56 | #66 |
| #5 | #15 | #25 | #35 | #45 | #55 | #65 |
| #4 | #14 | #24 | #34 | #44 | #54 | #64 |
| #3 | #13 | #23 | #33 | #43 | #53 | #63 |
| #2 | #12 | #22 | #32 | #42 | #52 | #62 |
| #1 | #11 | #21 | #31 | #41 | #51 | #61 |
| #0 | #10 | #20 | #30 | #40 | #50 | #60 |

SUBCARRIER

SYMBOL

: DMRS

# FIG. 16

START

MEASURE CHANNEL ENVIRONMENT — S400

DETERMINE LENGTH OF
MONITORING SECTION BASED — S410
ON MEASUREMENT RESULT

END

## FIG. 17

EP 4 765 699 A1

# FIG. 18

# FIG. 19

Home Gadget — 2100

2120

2200

Access Point

Home Appliances

2140

Entertainment

Europäisches
Patentamt

European
Patent Office

Office européen
des brevets

## EUROPEAN SEARCH REPORT

**Application Number**

EP 25 22 1603

### DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | WO 2014/164147 A1 (QUALCOMM INC [US]) 9 October 2014 (2014-10-09) | 1-10, 13-15 | INV. H04L1/00 H03M13/11 |
| A | * paragraph [0046] - paragraph [00108]; figures 2,5 * | 11,12 | |

-----

**TECHNICAL FIELDS SEARCHED (IPC)**

H04L
H03M

The present search report has been drawn up for all claims

| Place of search | Date of completion of the search | Examiner |
|---|---|---|
| Munich | 12 May 2026 | Martínez Martínez, V |

CATEGORY OF CITED DOCUMENTS

X : particularly relevant if taken alone
Y : particularly relevant if combined with another
    document of the same category
A : technological background
O : non-written disclosure
P : intermediate document

T : theory or principle underlying the invention
E : earlier patent document, but published on, or
    after the filing date
D : document cited in the application
L : document cited for other reasons

& : member of the same patent family, corresponding
    document

EPO FORM 1503 03.82 (P04C01)

## ANNEX TO THE EUROPEAN SEARCH REPORT
## ON EUROPEAN PATENT APPLICATION NO.

EP 25 22 1603

This annex lists the patent family members relating to the patent documents cited in the above-mentioned European search report.
The members are as contained in the European Patent Office EDP file on
The European Patent Office is in no way liable for these particulars which are merely given for the purpose of information.

12-05-2026

| Patent document cited in search report | Publication date | Patent family member(s) | | Publication date |
|---|---|---|---|---|
| WO 2014164147 A1 | 09-10-2014 | CN | 105027487 A | 04-11-2015 |
| | | EP | 2974100 A1 | 20-01-2016 |
| | | JP | 6067920 B2 | 25-01-2017 |
| | | JP | 2016516348 A | 02-06-2016 |
| | | JP | 2017050876 A | 09-03-2017 |
| | | KR | 20150121246 A | 28-10-2015 |
| | | US | 2014269627 A1 | 18-09-2014 |
| | | WO | 2014164147 A1 | 09-10-2014 |

EPO FORM P0459

For more details about this annex : see Official Journal of the European Patent Office, No. 12/82